# EUROPEAN PATENT APPLICATION

(11) **EP 4 517 830 A1**
(43) Date of publication of application: **05.03.2025**
(21) Application number: 24170485.7
(22) Date of filing: 16.04.2024
(51) Int. Cl.: H01L 29/10, H01L 29/06, H01L 29/08, H01L 29/51, H01L 29/66, H01L 29/775, B82Y 10/00

(54) **SEMICONDUCTOR DEVICE AND METHOD OF FABRICATING THE SAME**

(30) Priority: 04.09.2023 KR 20230117127
(71) Applicant: Samsung Electronics Co., Ltd., Suwon-si, Gyeonggi-do 16677 (KR)
(72) Inventor: LEE, Sunyoung, 16677 Suwon-si, Gyeonggi-do (KR); YU, Hyun-Kwan, 16677 Suwon-si, Gyeonggi-do (KR); KIM, Hyojin, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate including an active pattern, a channel pattern including a first semiconductor pattern and a second semiconductor pattern, a source/drain pattern connected to the first and second semiconductor patterns, and a gate electrode including an electrode between the first and second semiconductor patterns, and an insulating layer between the first and second semiconductor patterns and the electrode. The insulating layer includes a dielectric layer enclosing the electrode and a spacer on the dielectric layer. The spacer includes a horizontal portion between the dielectric layer and the second semiconductor pattern, a vertical portion between the dielectric layer and the source/drain pattern, and a corner portion connecting the horizontal portion to the vertical portion. A first thickness of the horizontal portion is smaller than a second thickness of the vertical portion, and the second thickness is smaller than a third thickness of the corner portion.

## Description

### CROSS-REFERENCE TO RELATED APPLICATIONS

This U.S. non-provisional patent application is based on and claims priority under 35 U.S.C. §119 to Korean Patent Application No. 10-2023-0117127, filed on September 4, 2023, in the Korean Intellectual Property Office, the entire contents of which are hereby incorporated by reference.

### BACKGROUND

The present disclosure relates to semiconductor devices and methods of fabricating the same, and in particular, to semiconductor devices including field effect transistors and methods of fabricating the same.

A semiconductor device includes an integrated circuit composed of metal-oxide-semiconductor field-effect transistors (MOS-FETs). To meet an increasing demand for a semiconductor device with a small pattern size and a reduced design rule, the MOS-FETs are being aggressively scaled down. The scale-down of the MOS-FETs may lead to deterioration in operational properties of the semiconductor device. A variety of studies are being conducted to overcome technical limitations associated with the scale-down of the semiconductor device and to realize high-performance semiconductor devices.

### SUMMARY

Some example embodiments of the inventive concepts provide a semiconductor device with improved electrical characteristics.

Some example embodiments of the inventive concepts provide methods of fabricating semiconductor devices with improved electrical characteristics.

According to some example embodiments of the inventive concepts, a semiconductor device may include a substrate including an active pattern, a channel pattern on the active pattern, the channel pattern including a first semiconductor pattern and a second semiconductor pattern, which are stacked to be spaced apart from each other, a source/drain pattern connected to the first and second semiconductor patterns, a gate electrode on the channel pattern, the gate electrode including an inner electrode interposed between the first and second semiconductor patterns, and a gate insulating layer between the first and second semiconductor patterns and the inner electrode. The gate insulating layer may include a high-k dielectric layer enclosing the inner electrode and an inner spacer on the high-k dielectric layer. The inner spacer may include a horizontal portion between the high-k dielectric layer and the second semiconductor pattern, a vertical portion between the high-k dielectric layer and the source/drain pattern, and a corner portion connecting the horizontal portion to the vertical portion. A first thickness of the horizontal portion may be smaller than a second thickness of the vertical portion, and the second thickness may be smaller than a third thickness of the corner portion.

According to some example embodiments of the inventive concepts, a semiconductor device may include a substrate including an active pattern, a channel pattern on the active pattern, the channel pattern including a first semiconductor pattern and a second semiconductor pattern, which are stacked to be spaced apart from each other, a source/drain pattern connected to the first and second semiconductor patterns, a gate electrode on the channel pattern, the gate electrode including an inner electrode interposed between the first and second semiconductor patterns, and a gate insulating layer between the first and second semiconductor patterns and the inner electrode. An inner region may be defined between the first and second semiconductor patterns and the source/drain pattern, and the inner region may include a first recess region formed in a corner thereof. The first recess region may be recessed in a direction away from the inner electrode, and the gate insulating layer may be provided to cover an inner surface of the inner region. A corner portion of the gate insulating layer may fill the first recess region.

According to some example embodiments of the inventive concepts, a semiconductor device may include a substrate including an active pattern, a channel pattern on the active pattern, the channel pattern including a first semiconductor pattern and a second semiconductor pattern, which are stacked to be spaced apart from each other, a source/drain pattern connected to the first and second semiconductor patterns, a gate electrode on the channel pattern, the gate electrode including an inner electrode interposed between the first and second semiconductor patterns, and a gate insulating layer between the first and second semiconductor patterns and the inner electrode. The source/drain pattern may include a protruding portion that protrudes toward the inner electrode, and the gate insulating layer may include a high-k dielectric layer enclosing the inner electrode and an inner spacer on the high-k dielectric layer. The inner spacer may include a horizontal portion between the high-k dielectric layer and the second semiconductor pattern, a vertical portion between the high-k dielectric layer and the protruding portion, and a corner portion connecting the horizontal portion to the vertical portion. A first side of the vertical portion may have a concave profile corresponding to the protruding portion, and a second side of the vertical portion may have a flat profile that is parallel to a vertical direction.

### BRIEF DESCRIPTION OF THE DRAWINGS

FIGS. 1 to 3 are conceptual diagrams illustrating logic cells of a semiconductor device according to some example embodiments of the inventive concepts.
FIG. 4 is a plan view illustrating a semiconductor device according to some example embodiments of the inventive concepts.
FIGS. 5A to 5D are sectional views, which are respectively taken along lines A-A', B-B', C-C', and D-D' of FIG. 4.
FIG. 6 is an enlarged view illustrating a portion M of FIG. 5A.
FIG. 7A is an enlarged view illustrating an example of a portion N of FIG. 6.
FIGS. 7B to 7H are enlarged views, each of which illustrates another example embodiment of the portion N of FIG. 6.
FIGS. 8A to 13C are sectional views illustrating methods of fabricating semiconductor devices, according to some example embodiments of the inventive concepts.
FIGS. 14A, 14B, and 14C are enlarged views illustrating methods of forming the portion N of FIG. 12A, according to some example embodiments of the inventive concepts.
FIGS. 15A, 15B, and 15C are enlarged views illustrating methods of forming the portion N of FIG. 12A, according to some example embodiments of the inventive concepts.

### DETAILED DESCRIPTION

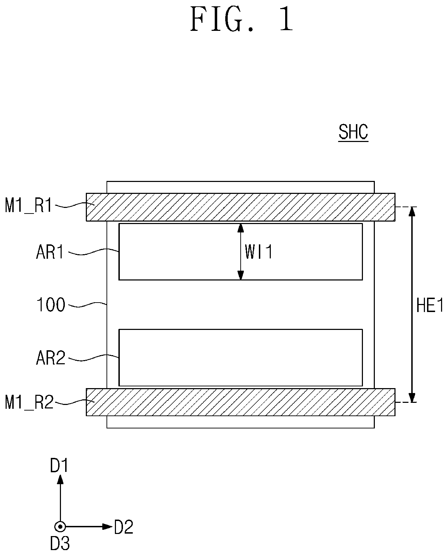

FIGS. 1 to 3 are conceptual diagrams illustrating logic cells of a semiconductor device according to example embodiments of the inventive concepts.

Referring to FIG. 1, a single height cell SHC may be provided. In detail, a first power line M1_R1 and a second power line M1_R2 may be provided on a substrate 100. The first power line M1_R1 may be a conduction path, to which a source voltage VSS (e.g., a ground voltage) is provided. The second power line M1_R2 may be a conduction path, to which a drain voltage VDD (e.g., a power voltage) is provided.

The single height cell SHC may be defined between the first power line M1_R1 and the second power line M1_R2. The single height cell SHC may include one first active region AR1 and one second active region AR2. One of the first and second active regions AR1 and AR2 may be a PMOSFET region, and the other may be an NMOSFET region. In other words, the single height cell SHC may have a CMOS structure provided between the first and second power lines M1_R1 and M1_R2.

Each of the first and second active regions AR1 and AR2 may have a first width WI1 in a first direction D1. A length of the single height cell SHC in the first direction D1 may be defined as a first height HE1. The first height HE1 may be substantially equal to a distance (e.g., a pitch) between the first and second power lines M1_R1 and M1_R2.

The single height cell SHC may constitute a single logic cell. In the present specification, the logic cell may mean a logic device (e.g., AND, OR, XOR, XNOR, inverter, and so forth), which is configured to execute a specific function. In other words, the logic cell may include transistors constituting the logic device and interconnection lines connecting the transistors to each other.

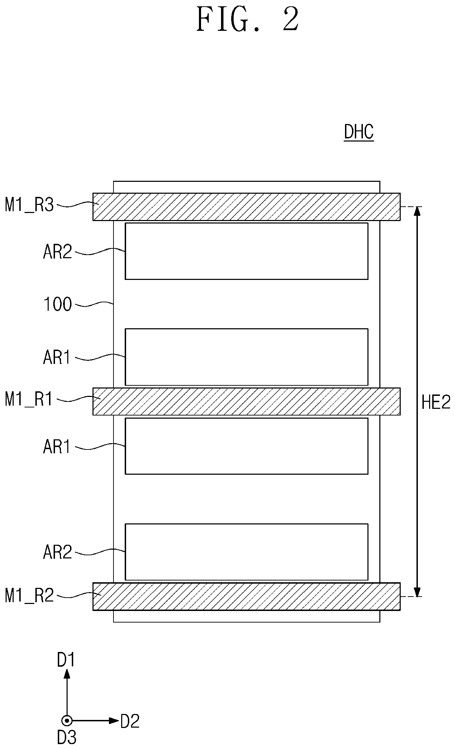

Referring to FIG. 2, a double height cell DHC may be provided. In detail, a first power line M1_R1, a second power line M1_R2, and a third power line M1_R3 may be provided on the substrate 100. The first power line M1_R1 may be disposed between the second power line M1_R2 and the third power line M1_R3. The third power line M1_R3 may be a conduction path, to which the source voltage VSS is provided.

The double height cell DHC may be defined between the second power line M1_R2 and the third power line M1_R3. The double height cell DHC may include a pair of first active regions AR1 and a pair of second active regions AR2.

One of the second active regions AR2 may be adjacent to the second power line M1_R2. The other of the second active regions AR2 may be adjacent to the third power line M1_R3. The pair of the first active regions AR1 may be adjacent to the first power line M1_R1. When viewed in a plan view, the first power line M1_R1 may be disposed between the pair of the first active regions AR1.

A length of the double height cell DHC in the first direction D1 may be defined as a second height HE2. The second height HE2 may be about two times the first height HE1 of FIG. 1. The pair of the first active regions AR1 of the double height cell DHC may be combined to serve as a single active region.

In some example embodiments, the double height cell DHC shown in FIG. 2 may be defined as a multi-height cell. Although not shown, the multi-height cell may include a triple height cell whose cell height is about three times that of the single height cell SHC.

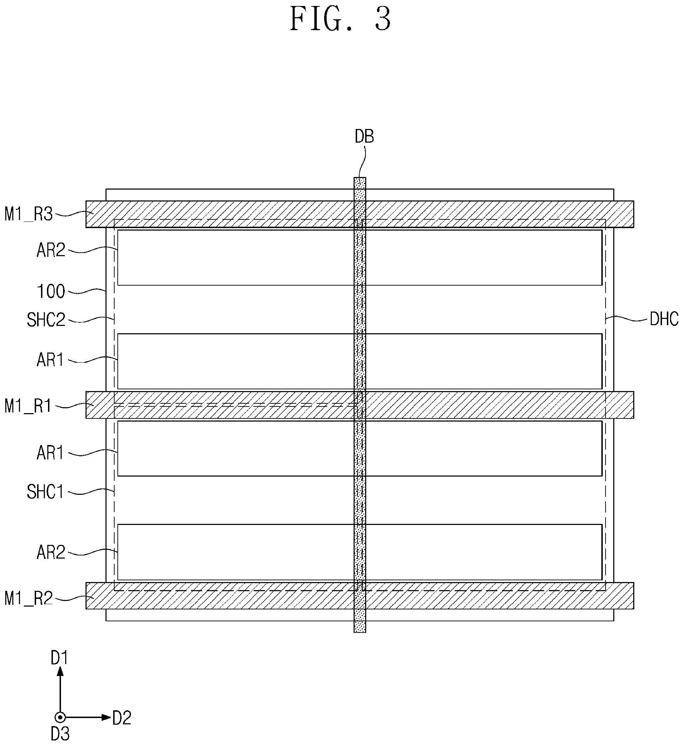

Referring to FIG. 3, a first single height cell SHC1, a second single height cell SHC2, and a double height cell DHC may be two-dimensionally arranged on the substrate 100. The first single height cell SHC1 may be disposed between the first and second power lines M1_R1 and M1_R2. The second single height cell SHC2 may be disposed between the first and third power lines M1_R1 and M1_R3. The second single height cell SHC2 may be adjacent to the first single height cell SHC1 in the first direction D1.

The double height cell DHC may be disposed between the second and third power lines M1_R2 and M1_R3. The double height cell DHC may be adjacent to the first and second single height cells SHC1 and SHC2 in a second direction D2.

A division structure DB may be provided between the first single height cell SHC1 and the double height cell DHC and between the second single height cell SHC2 and the double height cell DHC. The active region of the double height cell DHC may be electrically separated from the active region of each of the first and second single height cells SHC1 and SHC2 by the division structure DB.

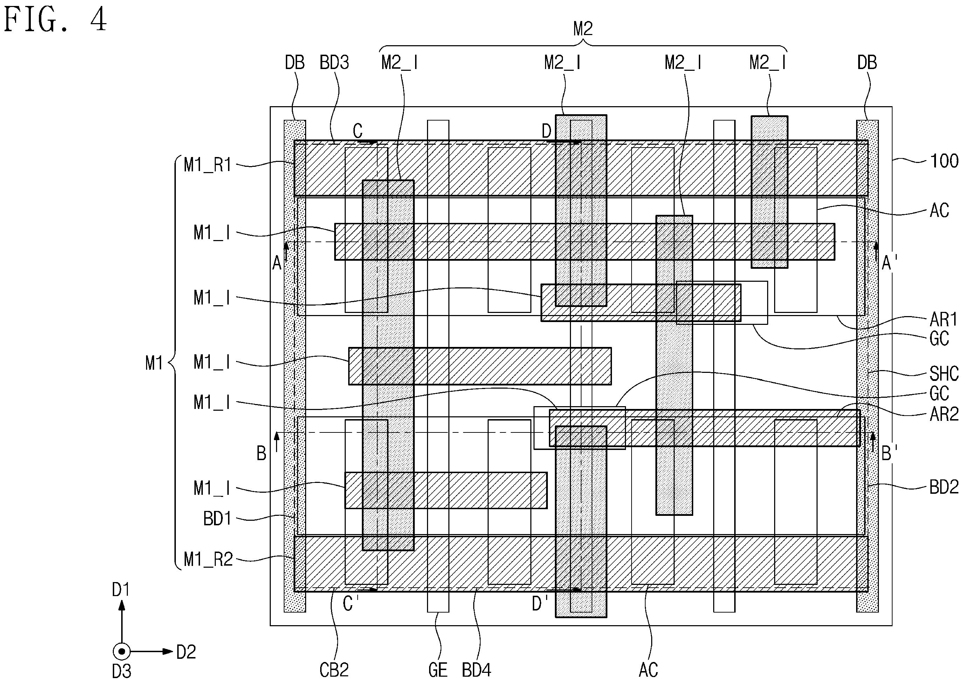

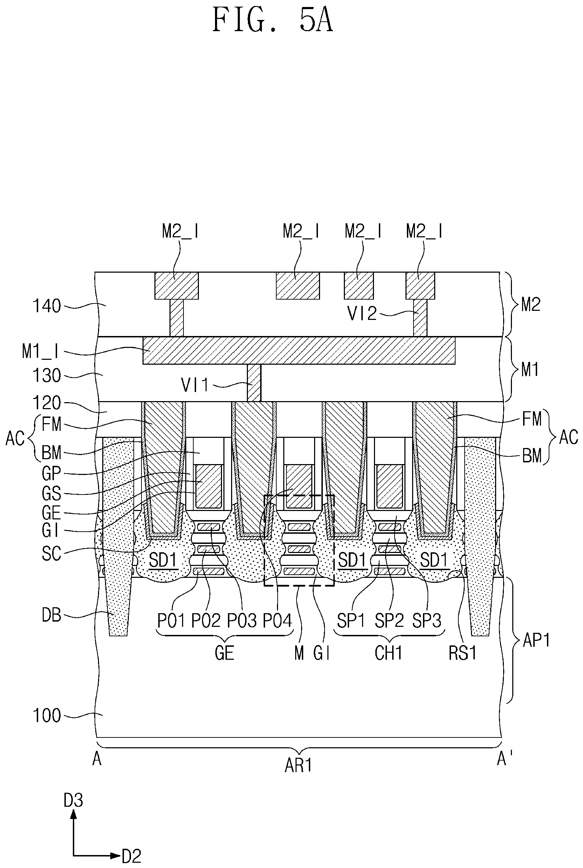

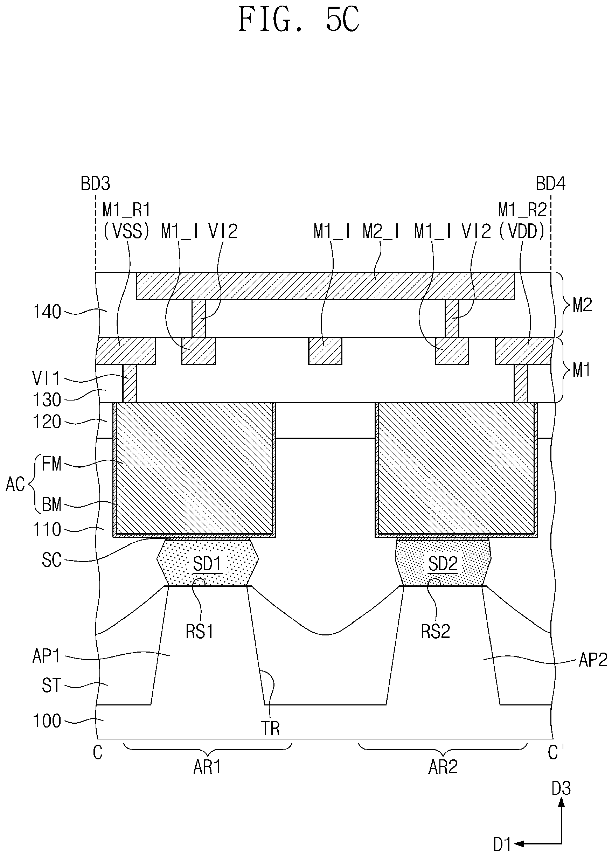

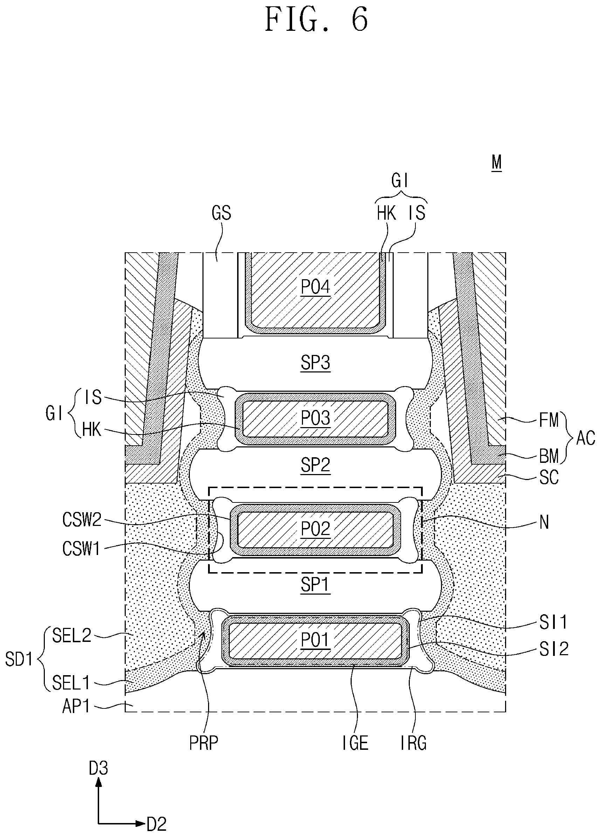

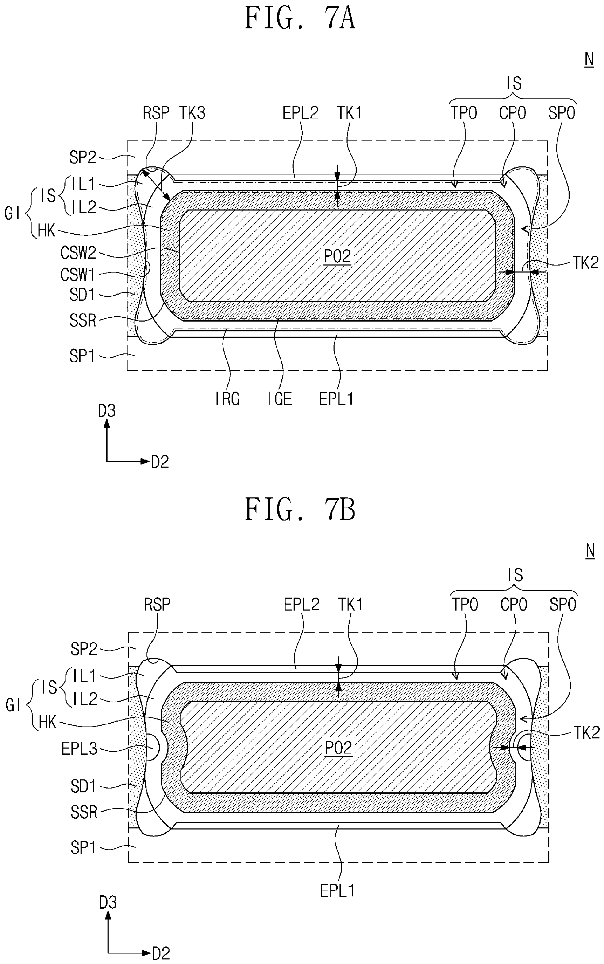

FIG. 4 is a plan view illustrating a semiconductor device according to some example embodiments of the inventive concepts. FIGS. 5A to 5D are sectional views, which are respectively taken along lines A-A', B-B', C-C', and D-D' of FIG. 4. FIG. 6 is an enlarged view illustrating a portion M of FIG. 5A. FIG. 7A is an enlarged view illustrating an example of a portion N of FIG. 6.

The semiconductor device of FIGS. 4 and 5A to 5D may be concrete example embodiments of the single height cell SHC of FIG. 1. Referring to FIGS. 4 and 5A to 5D, the single height cell SHC may be provided on the substrate 100. Logic transistors constituting a logic circuit may be disposed on the single height cell SHC. The substrate 100 may be a semiconductor substrate that is formed of or includes silicon, germanium, silicon germanium, a compound semiconductor material, or the like. In some example embodiments, the substrate 100 may be a silicon wafer.

The substrate 100 may include the first active region AR1 and the second active region AR2. Each of the first and second active regions AR1 and AR2 may be extended in the second direction D2. The first active region AR1 may be one of NMOSFET and PMOSFET regions, and the second active region AR2 may be the other of NMOSFET and PMOSFET regions. In some example embodiments, the first active region AR1 may be an NMOSFET region, and the second active region AR2 may be a PMOSFET region.

A first active pattern AP1 and a second active pattern AP2 may be defined by a trench TR, which is formed in an upper portion of the substrate 100. The first active pattern AP1 may be provided on the first active region AR1, and the second active pattern AP2 may be provided on the second active region AR2. The first and second active patterns AP1 and AP2 may be extended in the second direction D2. Each of the first and second active patterns AP1 and AP2 may be a vertically-protruding portion of the substrate 100.

A device isolation layer ST may be provided on the substrate 100. The device isolation layer ST may be provided to fill the trench TR. The device isolation layer ST may include a silicon oxide layer. The device isolation layer ST may not cover first and second channel patterns CH1 and CH2 to be described below.

A first channel pattern CH1 may be provided on the first active pattern AP1. A second channel pattern CH2 may be provided on the second active pattern AP2. Each of the first and second channel patterns CH1 and CH2 may include a first semiconductor pattern SP1, a second semiconductor pattern SP2, and a third semiconductor pattern SP3, which are sequentially stacked. The first to third semiconductor patterns SP1, SP2, and SP3 may be spaced apart from each other in a vertical direction (i.e., a third direction D3).

Each of the first to third semiconductor patterns SP1, SP2, and SP3 may be formed of or include at least one of silicon (Si), germanium (Ge), or silicon germanium (SiGe). For example, each of the first to third semiconductor patterns SP1, SP2, and SP3 may be formed of or include crystalline silicon.

Although the illustrated example refers to the first to third semiconductor patterns SP1, SP2, and SP3 forming the stacked nanosheets, is illustrated, the inventive concepts are not limited to this example. In some example embodiments, two or more nanosheets may be stacked.

A plurality of first source/drain patterns SD1 may be provided on the first active pattern AP1. A plurality of first recesses RS1 may be formed in an upper portion of the first active pattern AP1. The first source/drain patterns SD1 may be provided in the first recesses RS1, respectively. The first source/drain patterns SD1 may be impurity regions of a first conductivity type. The first channel pattern CH1 may be interposed between each pair of the first source/drain patterns SD1. In other words, each pair of the first source/drain patterns SD1 may be connected to each other by the stacked first to third semiconductor patterns SP1, SP2, and SP3.

A plurality of second source/drain patterns SD2 may be provided on the second active pattern AP2. A plurality of second recesses RS2 may be formed in an upper portion of the second active pattern AP2. The second source/drain patterns SD2 may be provided in the second recesses RS2, respectively. The second source/drain patterns SD2 may be impurity regions of a second conductivity type. The second channel pattern CH2 may be interposed between each pair of the second source/drain patterns SD2. In other words, each pair of the second source/drain patterns SD2 may be connected to each other by the stacked first to third semiconductor patterns SP1, SP2, and SP3.

The first conductivity type of the first source/drain pattern SD1 may be one of n- and p-types, and the second conductivity type of the second source/drain pattern SD2 may be the other of the n- and p-types. In some example embodiments, the first conductivity type may be the n-type, and the second conductivity type may be the p-type.

The first and second source/drain patterns SD1 and SD2 may be epitaxial patterns, which are formed by a selective epitaxial growth (SEG) process. In some example embodiments, each of the first and second source/drain patterns SD1 and SD2 may have a top surface that is higher than a top surface of the third semiconductor pattern SP3. In another example embodiment, a top surface of at least one of the first and second source/drain patterns SD1 and SD2 may be located at substantially the same level as the top surface of the third semiconductor pattern SP3.

In some example embodiments, the first source/drain patterns SD1 may be formed of or include the same semiconductor element (e.g., Si) as the substrate 100. The second source/drain patterns SD2 may include a semiconductor material (e.g., SiGe) whose lattice constant is greater than that of the substrate 100. In this case, the pair of the second source/drain patterns SD2 may exert a compressive stress on the second channel pattern CH2 therebetween.

A side surface of each of the first and second source/drain patterns SD1 and SD2 may have an uneven or embossing shape. In other words, the side surface of each of the first and second source/drain patterns SD1 and SD2 may have a wavy profile. The side surface of each of the first and second source/drain patterns SD1 and SD2 may protrude toward first to third inner electrodes PO1, PO2, and PO3 of a gate electrode GE, which will be described below.

Gate electrodes GE may be provided to cross the first and second channel patterns CH1 and CH2 and to extend in the first direction D1. The gate electrodes GE may be arranged at a first pitch in the second direction D2. Each of the gate electrodes GE may be vertically overlapped with the first and second channel patterns CH1 and CH2.

The gate electrode GE may include a first inner electrode PO1 interposed between the active pattern AP1 or AP2 and the first semiconductor pattern SP1, a second inner electrode PO2 interposed between the first semiconductor pattern SP1 and the second semiconductor pattern SP2, a third inner electrode PO3 interposed between the second semiconductor pattern SP2 and the third semiconductor pattern SP3, and an outer electrode PO4 on the third semiconductor pattern SP3.

Although some example embodiments illustrating three inner electrodes being stacked are provided, the inventive concepts are not limited to this particular example. The gate electrode GE may include two or more inner electrodes.

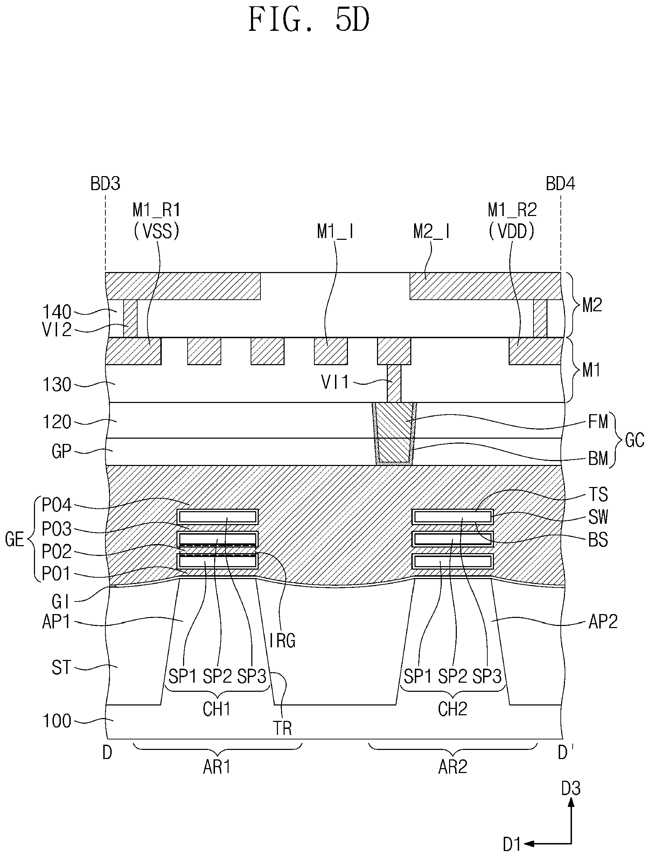

Referring to FIG. 5D, the gate electrode GE may be provided on a top surface TS, a bottom surface BS, and opposite side surfaces SW of each of the first to third semiconductor patterns SP1, SP2, and SP3. That is, the transistor according to some example embodiments may be a three-dimensional field effect transistor (e.g., NMCFET or GAAFET) in which the gate electrode GE is provided to three-dimensionally surround the channel pattern.

Referring back to FIGS. 4 and 5A to 5D, a pair of gate spacers GS may be respectively disposed on opposite side surfaces of the outer electrode PO4 of the gate electrode GE. The gate spacers GS may be extended along the gate electrode GE and in the first direction D1. Top surfaces of the gate spacers GS may be higher than a top surface of the gate electrode GE. In some example embodiments, the gate spacers GS may be formed of or include at least one of silicon carbon nitride (SiCN), silicon carbon oxynitride (SiCON), or silicon nitride (SiN). In other example embodiments, the gate spacers GS may be provided to have a multi-layered structure, which includes at least two different materials selected from silicon carbon nitride (SiCN), silicon carbon oxynitride (SiCON), and/or silicon nitride (SiN).

A gate capping pattern GP may be provided on the gate electrode GE. The gate capping pattern GP may be extended along the gate electrode GE and in the first direction D1. The gate capping pattern GP may be formed of or include a material having an etch selectivity with respect to first and second interlayer insulating layers 110 and 120, which will be described below. In detail, the gate capping pattern GP may be formed of or include at least one of silicon oxynitride (SiON), silicon carbon nitride (SiCN), silicon carbon oxynitride (SiCON), or silicon nitride (SiN).

A gate insulating layer GI may be interposed between the gate electrode GE and the first channel pattern CH1 and between the gate electrode GE and the second channel pattern CH2. The gate insulating layer GI may directly cover the top surface TS, the bottom surface BS, and the opposite side surfaces SW of each of the first to third semiconductor patterns SP1, SP2, and SP3. The gate insulating layer GI may cover a top surface of the device isolation layer ST placed below the gate electrode GE.

In some example embodiments, referring to FIG. 7A, the gate insulating layer GI may include an inner spacer IS and a high-k dielectric layer HK. In some example embodiments, the inner spacer IS may include a first insulating layer IL1 and a second insulating layer IL2. Each of the first and second insulating layers IL1 and IL2 may be formed of or include a silicon-containing insulating material. Each of the first and second insulating layers IL1 and IL2 may include a silicon oxide layer, a silicon oxynitride layer, or a silicon nitride layer.

The high-k dielectric layer HK may be formed of or include at least one of high-k dielectric materials whose dielectric constants are higher than that of silicon oxide. As an example, the high-k dielectric layer HK may be formed of or include at least one of, for example, hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

Referring back to FIGS. 4 and 5A to 5D, the gate electrode GE may include a first metal pattern and a second metal pattern on the first metal pattern. The first metal pattern may be provided on the gate insulating layer GI and may be adjacent to the first to third semiconductor patterns SP1, SP2, and SP3. The first metal pattern may include a work-function metal, which can be used to adjust a threshold voltage of the transistor. By adjusting a thickness and composition of the first metal pattern, it may be possible to realize a transistor having a desired threshold voltage. For example, the first to third inner electrodes PO1, PO2, and PO3 of the gate electrode GE may be composed of the first metal pattern or the work-function metal.

The first metal pattern may include a metal nitride layer. For example, the first metal pattern may include a layer that is composed of at least one metallic material, which is selected from the group consisting of titanium (Ti), tantalum (Ta), aluminum (Al), tungsten (W) and molybdenum (Mo), and nitrogen (N). In some example embodiments, the first metal pattern may further include carbon (C). The first metal pattern may include a plurality of work function metal layers which are stacked.

The second metal pattern may be formed of or include a metallic material whose resistance is lower than the first metal pattern. For example, the second metal pattern may be formed of or include at least one metallic material, which is selected from the group consisting of tungsten (W), aluminum (Al), titanium (Ti), and tantalum (Ta). The outer electrode PO4 of the gate electrode GE may include the first metal pattern and the second metal pattern on the first metal pattern.

A first interlayer insulating layer 110 may be provided on the substrate 100. The first interlayer insulating layer 110 may cover the gate spacers GS and the first and second source/drain patterns SD1 and SD2. The first interlayer insulating layer 110 may have a top surface that is substantially coplanar with the top surface of the gate capping pattern GP and the top surface of the gate spacer GS. A second interlayer insulating layer 120 may be formed on the first interlayer insulating layer 110 to cover the gate capping pattern GP. A third interlayer insulating layer 130 may be provided on the second interlayer insulating layer 120. A fourth interlayer insulating layer 140 may be provided on the third interlayer insulating layer 130. In some example embodiments, at least one of the first to fourth interlayer insulating layers 110 to 140 may include a silicon oxide layer.

The single height cell SHC may have a first border BD1 and a second border BD2, which are opposite to each other in the second direction D2. The first and second borders BD1 and BD2 may be extended in the first direction D1. The single height cell SHC may have a third border BD3 and a fourth border BD4, which are opposite to each other in the first direction D1. The third and fourth borders BD3 and BD4 may be extended in the second direction D2.

A pair of division structures DB, which are opposite to each other in the second direction D2, may be provided at both sides of the single height cell SHC. For example, the pair of the division structures DB may be respectively provided on the first and second borders BD1 and BD2 of the single height cell SHC. The division structure DB may be extended in the first direction D1 to be parallel to the gate electrodes GE. A pitch between the division structure DB and the gate electrode GE adjacent thereto may be equal to the first pitch.

The division structure DB may be provided to penetrate the gate capping pattern GP and the gate electrode GE and may be extended into the first and second active patterns AP1 and AP2. The division structure DB may be provided to penetrate an upper portion of each of the first and second active patterns AP1 and AP2. The division structure DB may electrically separate an active region of each of the single height cell SHC from an active region of a neighboring cell.

Active contacts AC may be provided to penetrate the first and second interlayer insulating layers 110 and 120 and to be electrically connected to the first and second source/drain patterns SD1 and SD2, respectively. A pair of the active contacts AC may be respectively provided at both sides of the gate electrode GE. When viewed in a plan view, the active contact AC may be a bar-shaped pattern that is extended in the first direction D1.

The active contact AC may be a self-aligned contact. For example, the active contact AC may be formed by a self-alignment process using the gate capping pattern GP and the gate spacer GS. For example, the active contact AC may cover at least a portion of the side surface of the gate spacer GS. Although not shown, the active contact AC may cover a portion of the top surface of the gate capping pattern GP.

Metal-semiconductor compound layers SC (e.g., silicide layers) may be respectively interposed between the active contact AC and the first source/drain pattern SD1 and between the active contact AC and the second source/drain pattern SD2. The active contact AC may be electrically connected to the source/drain pattern SD1 or SD2 through the metal-semiconductor compound layer SC. For example, the metal-semiconductor compound layer SC may be formed of or include at least one of titanium silicide, tantalum silicide, tungsten silicide, nickel silicide, or cobalt silicide.

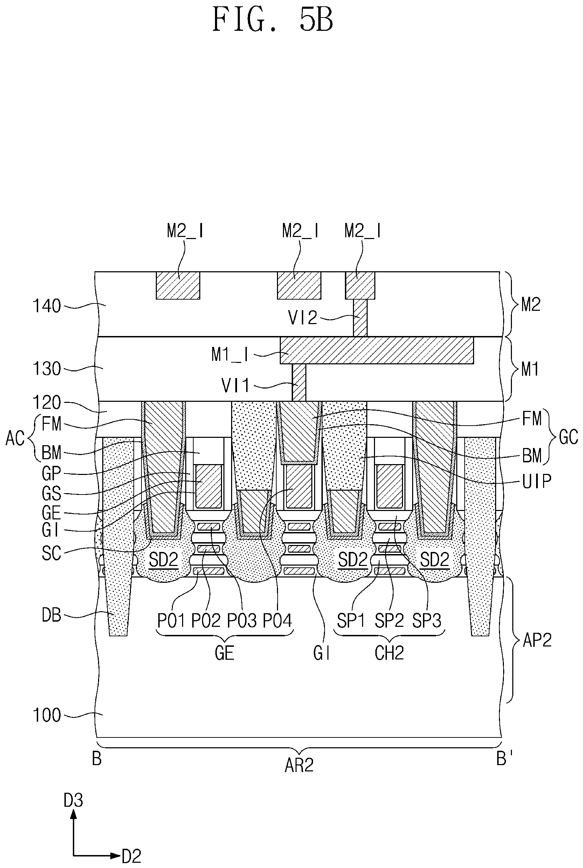

Gate contacts GC may be provided to penetrate the second interlayer insulating layer 120 and the gate capping pattern GP and to be electrically connected to the gate electrodes GE, respectively. When viewed in a plan view, the gate contacts GC may be disposed to be respectively overlapped with the first and second active regions AR1 and AR2. As an example, the gate contact GC may be provided on the second active pattern AP2 (e.g., see FIG. 5B).

In some example embodiments, referring to FIG. 5B, an upper portion of the active contact AC adjacent to the gate contact GC may be filled with an upper insulating pattern UIP. A bottom surface of the upper insulating pattern UIP may be lower than a bottom surface of the gate contact GC. In other words, a top surface of the active contact AC adjacent to the gate contact GC may be formed at a level, which is lower than the bottom surface of the gate contact GC, by the upper insulating pattern UIP. Accordingly, it may be possible to prevent or reduce in likelihood the gate contact GC and the active contact AC, which are adjacent to each other, from being in contact with each other and thereby to prevent or reduce in likelihood a short circuit issue from occurring therebetween.

Each of the active and gate contacts AC and GC may include a conductive pattern FM and a barrier pattern BM enclosing the conductive pattern FM. For example, the conductive pattern FM may be formed of or include at least one of metallic materials (e.g., aluminum, copper, tungsten, molybdenum, and/or cobalt). The barrier pattern BM may be provided to cover side and bottom surfaces of the conductive pattern FM. In some example embodiments, the barrier pattern BM may include a metal layer and a metal nitride layer. The metal layer may be formed of or include at least one of titanium, tantalum, tungsten, nickel, cobalt, or platinum. The metal nitride layer may be formed of or include at least one of titanium nitride (TiN), tantalum nitride (TaN), tungsten nitride (WN), nickel nitride (NiN), cobalt nitride (CoN), or platinum nitride (PtN).

A first metal layer M1 may be provided in the third interlayer insulating layer 130. For example, the first metal layer M1 may include the first power line M1_R1, the second power line M1_R2, and first interconnection lines M1_I. Each of the interconnection lines M1_R1, M1_R2, and M1_I of the first metal layer M1 may be extended in the second direction D2 and parallel to each other.

In detail, the first and second power lines M1_R1 and M1_R2 may be respectively provided on the third and fourth borders BD3 and BD4 of the single height cell SHC. The first power line M1_R1 may be extended along the third border BD3 and in the second direction D2. The second power line M1_R2 may be extended along the fourth border BD4 and in the second direction D2.

The first interconnection lines M1_I of the first metal layer M1 may be disposed between the first and second power lines M1_R1 and M1_R2. The first interconnection lines M1_I of the first metal layer M1 may be arranged at a second pitch in the first direction D1. The second pitch may be smaller than the first pitch. A linewidth of each of the first interconnection lines M1_I may be smaller than a linewidth of each of the first and second power lines M1_R1 and M1_R2.

The first metal layer M1 may further include first vias VI1. The first vias VI1 may be respectively disposed below the interconnection lines M1_R1, M_R2, and M1_I of the first metal layer M1. The active contact AC and the interconnection line of the first metal layer M1 may be electrically connected to each other through the first via VI1. The gate contact GC and the interconnection line of the first metal layer M1 may be electrically connected to each other through the first via VI1.

The interconnection line of the first metal layer M1 and the first via VI1 thereunder may be formed by separate processes. For example, the interconnection line and the first via VI1 of the first metal layer M1 may be independently formed by respective single damascene processes. The semiconductor device according to the present example embodiments may be fabricated using a sub-20 nm process.

A second metal layer M2 may be provided in the fourth interlayer insulating layer 140. The second metal layer M2 may include a plurality of second interconnection lines M2_I. Each of the second interconnection lines M2_I of the second metal layer M2 may be a line- or bar-shaped pattern that is extended in the first direction D1. In other words, the second interconnection lines M2_I may be extended in the first direction D1 and parallel to each other.

The second metal layer M2 may further include second vias VI2, which are respectively provided below the second interconnection lines M2_I. The interconnection lines of the first and second metal layers M1 and M2 may be electrically connected to each other through the second via VI2. The interconnection line of the second metal layer M2 and the second via VI2 thereunder may be formed together by a dual damascene process.

The interconnection lines of the first metal layer M1 may be formed of or include a conductive material that is the same as or different from those of the second metal layer M2. For example, the interconnection lines of the first and second metal layers M1 and M2 may be formed of or include at least one of metallic materials (e.g., aluminum, copper, tungsten, ruthenium, molybdenum, and cobalt). Although not shown, a plurality of metal layers (e.g., M3, M4, M5, and so forth) may be additionally stacked on the fourth interlayer insulating layer 140. Each of the stacked metal layers may include interconnection lines, which are used as routing paths between cells.

The inner spacer IS on the first channel pattern CH1 will be described in more detail with reference to FIGS. 6 and 7A. Referring to FIG. 6, the first source/drain pattern SD1 may include protruding portions PRP which protrude toward the first to third inner electrodes PO1, PO2, and PO3 of the gate electrode GE. The protruding portion PRP of the first source/drain pattern SD1 may have a first sidewall CSW1. In the present example embodiments, the first sidewall CSW1 may have a shape that is convex toward a corresponding portion of the first to third inner electrodes PO1, PO2, and PO3.

Each of the first to third inner electrodes PO1, PO2, and PO3 of the gate electrode GE may have a second sidewall CSW2. The second sidewall CSW2 may be vertically extended in the third direction D3. The second sidewall CSW2 may have a flat profile that is parallel to the third direction D3. The second sidewall CSW2 may protrude toward the first sidewall CSW1 of the first source/drain pattern SD1.

In some present example embodiments, each of the first to third inner electrodes PO1, PO2, and PO3 may not have a curved (e.g., concave) sidewall, unlike the first sidewall CSW1 of the first source/drain pattern SD1. As will be described below, this is because the inner spacer IS provides an inner gate space IGE, allowing the inner electrodes PO1, PO2, and PO3 to have the second sidewalls CSW2.

According to some example embodiments of the inventive concept, the first to third inner electrodes PO1, PO2, and PO3 may have different widths from each other. For example, the largest width of the first inner electrode PO1 in the second direction D2 may be larger than the largest width of the second inner electrode PO2 in the second direction D2. The largest width of the second inner electrode PO2 in the second direction D2 may be larger than the largest width of the first inner electrode PO1 in the second direction D2.

The first source/drain pattern SD1 may include a first semiconductor layer SEL1 and a second semiconductor layer SEL2 on the first semiconductor layer SEL1. In the case where the first source/drain pattern SD1 is of an n-type, the first semiconductor layer SEL1 may be formed of or include the same semiconductor material (e.g., silicon (Si)) as the second semiconductor layer SEL2. However, a concentration of the n-type impurities (e.g., phosphorus or arsenic) in the second semiconductor layer SEL2 may be higher than a concentration of the n-type impurities in the first semiconductor layer SEL1.

In the case where the first source/drain pattern SD1 is of a p-type, the first semiconductor layer SEL1 may be formed of or include the same semiconductor material (e.g., silicon-germanium (SiGe)) as the second semiconductor layer SEL2. However, a germanium concentration of the second semiconductor layer SEL2 may be higher than a germanium concentration of the first semiconductor layer SEL1. In addition, a concentration of p-type impurities (e.g., boron) in the second semiconductor layer SEL2 may be higher than a concentration of p-type impurities in the first semiconductor layer SEL1.

The first semiconductor layer SEL1 may be in contact, for example direct contact, with the first to third semiconductor patterns SP1, SP2, and SP3. The first semiconductor layer SEL1 may include the protruding portions PRP. The inner spacer IS may cover, for example directly cover, the first semiconductor layer SEL1. The first to third inner electrodes PO1, PO2, and PO3 of the gate electrode GE may be spaced apart from the first semiconductor layer SEL1, with the inner spacer IS interposed therebetween.

Inner regions IRG may be provided between a pair of first source/drain patterns SD1. The first to third inner electrodes PO1, PO2, and PO3 of the gate electrode GE may be respectively provided in the inner regions IRG. The inner spacer IS and the high-k dielectric layer HK may be further provided in each of the inner regions IRG. The high-k dielectric layer HK may have an exterior surface SSR.

The inner spacer IS may be provided to partially fill the inner region IRG. The inner spacer IS may provide an inner gate space IGE. That is, a remaining space within the inner region IRG other than the inner spacer IS may be defined as the inner gate space IGE. The high-k dielectric layer HK and the inner electrode PO1, PO2, or PO3 may be provided in the inner gate space IGE.

A first side SI1 of the inner region IRG may have a concave shape that corresponds to the first sidewall CSW1. A second side SI2 of the inner gate space IGE may have a vertically-extended shape (e.g., in the third direction D3) that corresponds to the second sidewall CSW2. The second side SI2 may have a flat profile that is parallel to the third direction D3. The inner spacer IS may allow the second side SI2 of the inner gate space IGE to have a vertically linear profile, unlike the concave profile of the first side SI1 of the inner region IRG.

Hereinafter, the second inner electrode PO2 and the gate insulating layer GI enclosing the second inner electrode PO2 will be described in more detail with reference to FIG. 7A. The gate insulating layer GI may be interposed between the second inner electrode PO2 and the first semiconductor pattern SP1, between the second inner electrode PO2 and the second semiconductor pattern SP2, and between the second inner electrode PO2 and the first source/drain pattern SD1.

A first epitaxial layer EPL1 may be interposed between the gate insulating layer GI and the first semiconductor pattern SP1. A second epitaxial layer EPL2 may be interposed between the gate insulating layer GI and the second semiconductor pattern SP2.

According to some example embodiments of the inventive concepts, the first and second epitaxial layers EPL1 and EPL2 may be formed of or include crystalline silicon. Since the first epitaxial layer EPL1 and the first semiconductor pattern SP1 include the same material (i.e., silicon), there may be no border therebetween. Since the second epitaxial layer EPL2 and the second semiconductor pattern SP2 include the same material (i.e., silicon), there may be no border therebetween.

In the present example embodiments, a thickness of each of the first and second semiconductor patterns SP1 and SP2 in the third direction D3 may be increased, due to the presence of the first and second epitaxial layers EPL1 and EPL2. This may make it possible to reduce the channel resistance of a transistor and thereby improve the electric characteristics of the transistor.

The gate insulating layer GI may include the inner spacer IS and the high-k dielectric layer HK. The inner spacer IS may include the first insulating layer IL1 and the second insulating layer IL2 on the first insulating layer II,1. The high-k dielectric layer HK may be interposed between the inner spacer IS and the second inner electrode PO2. The high-k dielectric layer HK may cover, for example directly cover, a surface of the second inner electrode PO2.

A recess region RSP may be defined at a corner of the inner region IRG. The recess region RSP may be a region that is recessed in a direction away from the second inner electrode PO2. The recess region RSP may be formed by recessing a portion of the semiconductor patterns SP1 and SP2 and a portion of the first source/drain pattern SD1. The first insulating layer IL1 may fill at least a portion of the recess region RSP. The first insulating layer IL1 may cover, for example directly cover, at least a portion of the first sidewall CSW1 of the first source/drain pattern SD1.

The first insulating layer IL1 may not cover the first and second epitaxial layers EPL1 and EPL2. The first insulating layer IL1 may be provided to expose the first and second epitaxial layers EPL1 and EPL2. In some example embodiments, each of the first and second epitaxial layers EPL1 and EPL2 may include an end portion that is in contact with an end portion of the first insulating layer II,1.

The second insulating layer IL2 may be interposed between the first insulating layer IL1 and the high-k dielectric layer HK. The second insulating layer IL2 may cover, for example directly cover, at least a portion of the first epitaxial layer EPL1. The second insulating layer IL2 may cover, for example directly cover, at least a portion of the second epitaxial layer EPL2. The second insulating layer IL2 may cover, for example directly cover, at least a portion of the first sidewall CSW1 of the first source/drain pattern SD1.

Each of the first and second insulating layers IL1 and IL2 may be formed of or include a silicon-containing insulating material. Each of the first and second insulating layers IL1 and IL2 may include a silicon oxide layer, a silicon oxynitride layer, or a silicon nitride layer. According to some example embodiments of the inventive concepts, all of the first and second insulating layers IL1 and IL2 may include a silicon oxide layer. In the case where the first and second insulating layers IL1 and IL2 include the same material (i.e., silicon oxide), there may be no border therebetween. That is, the first and second insulating layers IL1 and IL2 constituting the inner spacer IS may be provided as a single silicon oxide layer.

In other example embodiments of the inventive concepts, the first insulating layer IL1 may include a silicon nitride layer, and the second insulating layer IL2 may include a silicon oxide layer. In this case, there may be an observable border between the first and second insulating layers IL1 and IL2.

In still other example embodiments of the inventive concepts, the first insulating layer IL1 may be an air gap. That is, a corner portion CPO of the inner spacer IS, which will be described below, may include an air gap. In this case, it may be possible to reduce the parasitic capacitance, which is caused by the inner spacer IS.

The inner spacer IS may include a horizontal portion TPO between the second semiconductor pattern SP2 and the high-k dielectric layer HK. The inner spacer IS may include a vertical portion SPO between the high-k dielectric layer HK and the first source/drain pattern SD1. The inner spacer IS may include a corner portion CPO between the high-k dielectric layer HK and the recess region RSP. The corner portion CPO may connect the horizontal portion TPO to the vertical portion SPO. In some example embodiments, each of the horizontal and vertical portions TPO and SPO may be composed of the second insulating layer IL2. The corner portion CPO may be composed of the first and second insulating layers IL1 and IL2.

A thickness of the inner spacer IS may be a sum of thicknesses of the first and second insulating layers IL1 and IL2. The horizontal portion TPO of the inner spacer IS may have a first thickness TK1. The first thickness TK1 may be smaller than a thickness of the high-k dielectric layer HK. The vertical portion SPO of the inner spacer IS may have a second thickness TK2. The second thickness TK2 may be larger than the first thickness TK1. The corner portion CPO of the inner spacer IS may have a third thickness TK3. The third thickness TK3 may be larger than the second thickness TK2. The third thickness TK3 may be larger than the thickness of the high-k dielectric layer HK.

In the present example embodiments, the high-k dielectric layer HK may have a uniform thickness. However, in the case of the inner spacer IS, the thickness TK1 of the horizontal portion TPO, the thickness TK2 of the vertical portion SPO, and the thickness TK3 of the corner portion CPO may be different from each other. As a result, the inner gate space IGE, which is provided by the inner spacer IS, may have a different shape from the inner region IRG.

The inner spacer IS shown in FIG. 7A may be commonly used in not only the NMOSFET but also the PMOSFET. In some example embodiments, the inner spacer IS of FIG. 7A may be provided in only the NMOSFET and may be omitted from the PMOSFET. In other example embodiments of the inventive concepts, the inner spacer IS of FIG. 7A may be provided in only the PMOSFET and may be omitted from the NMOSFET. In still other example embodiments of the inventive concepts, the inner spacer IS of FIG. 7A may be provided in both of the PMOSFET and NMOSFET.

According to some example embodiments of the inventive concepts, since the inner spacer IS includes the corner portion CPO with a relatively large thickness (i.e., TK3), a leakage current of a transistor may be effectively reduced. In addition, since the inner spacer IS includes the horizontal portion TPO with a relatively small thickness (i.e., TK1), it may be possible to secure the inner gate space IGE, which allows for the stable formation of the second inner electrode PO2, between the first and second semiconductor patterns SP1 and SP2. As a result, it may be possible to improve the electrical and reliability characteristics of the semiconductor device.

FIGS. 7B to 7H are enlarged views, each of which illustrates another example of the portion N of FIG. 6. In the following description, an element previously described with reference to FIGS. 1 to 7A may be identified by the same reference number without repeating an overlapping description thereof, for concise description.

Referring to FIG. 7B, a third epitaxial layer EPL3 may be provided on the first sidewall CSW1 of the first source/drain pattern SD1. The third epitaxial layer EPL3 may be formed of or include the same material as the first and second epitaxial layers EPL1 and EPL2. The first insulating layer IL1 may be provided to expose the third epitaxial layer EPL3.

The vertical portion SPO of the inner spacer IS may directly cover the third epitaxial layer EPL3. Due to the presence of the third epitaxial layer EPL3, the vertical portion SPO may have a curved profile. The vertical portion SPO on the third epitaxial layer EPL3 may have the second thickness TK2. In some example embodiments, the second thickness TK2 may be equal to or smaller than the first thickness TK1 of the horizontal portion TPO. Alternatively, the second thickness TK2 may be larger than the first thickness TK1.

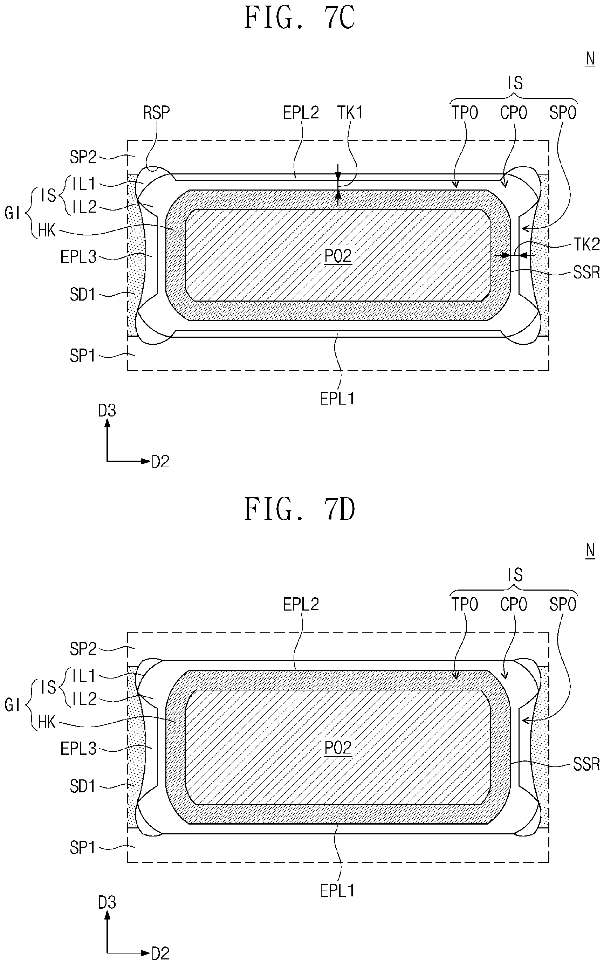

Referring to FIG. 7C, the third epitaxial layer EPL3 may be provided on the first sidewall CSW1 of the first source/drain pattern SD1. The first insulating layer IL1 may be provided to expose the third epitaxial layer EPL3. When compared with the third epitaxial layer EPL3 of FIG. 7B, the third epitaxial layer EPL3 of FIG. 7C may have a shape extending in the third direction D3.

The vertical portion SPO of the inner spacer IS may cover, for example directly cover, the third epitaxial layer EPL3. The vertical portion SPO on the third epitaxial layer EPL3 may have the second thickness TK2. In some example embodiments, the second thickness TK2 may be equal to or smaller than the first thickness TK1 of the horizontal portion TPO. Alternatively, the second thickness TK2 may be larger than the first thickness TK1.

Referring to FIG. 7D, only the third epitaxial layer EPL3 may be present on the first sidewall CSW1 of the first source/drain pattern SD1, and the first and second epitaxial layers EPL1 and EPL2 may be absent. As a result, the inner gate space IGE in the present example embodiments may be larger than the inner gate space IGE of FIG. 7A.

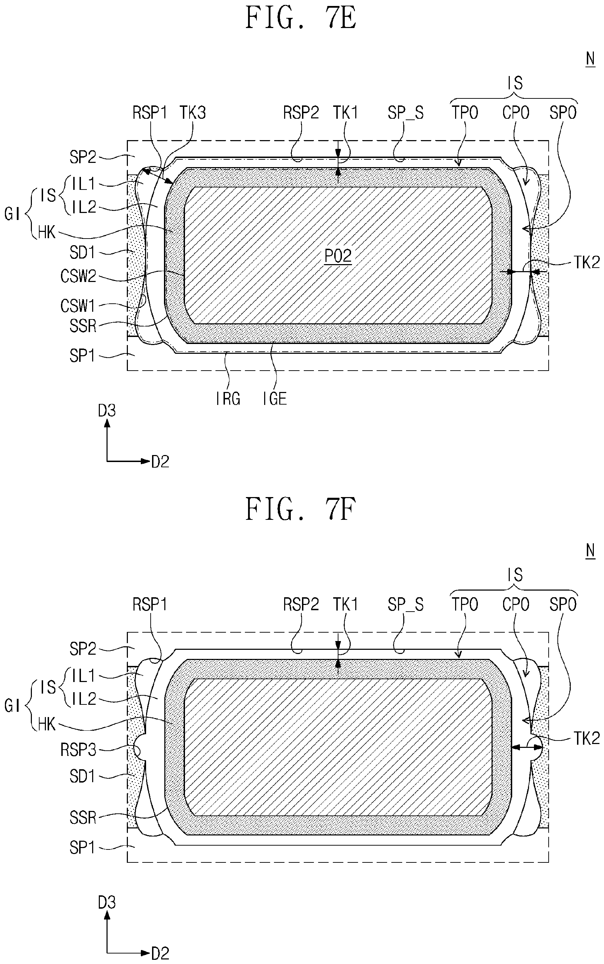

Referring to FIG. 7E, a first recess region RSP1 may be defined at a corner of the inner region IRG. A second recess region RSP2 may be additionally defined at each of upper and lower portions of the inner region IRG. The second recess region RSP2 may be a recessed portion of a top surface of the first semiconductor pattern SP1. The second recess region RSP2 may be a recessed portion of a bottom surface of the second semiconductor pattern SP2. In the present example embodiments, owing to the second recess region RSP2, the inner gate space IGE may be larger than the inner gate space IGE of FIG. 7A.

In some example embodiments, the second semiconductor pattern SP2 may include a bottom surface SP_S defining the second recess region RSP2. The second insulating layer IL2 of the inner spacer IS may cover, for example directly cover, the bottom surface SP_S. The bottom surface SP_S of the second semiconductor pattern SP2 may be higher than the corner portion CPO of the inner spacer IS.

The horizontal portion TPO of the inner spacer IS may have the first thickness TK1, the vertical portion SPO may have the second thickness TK2, and the corner portion CPO may have the third thickness TK3. The second thickness TK2 may be larger than the first thickness TK1, and the third thickness TK3 may be larger than the second thickness TK2.

In the present example embodiments, due to the presence of the second recess region RSP2, the inner gate space IGE may have a relatively large volume, and as a result, the second inner electrode PO2 may also have a relatively large volume. In this case, the channel controllability by the second inner electrode PO2 may be improved.

In other example embodiments, the semiconductor patterns SP1-SP3 and the inner electrodes PO1-PO3 of FIG. 6 may have tier-dependent shapes. For example, a large amount of current may pass through the third semiconductor pattern SP3 located at a top tier, during an operation of a transistor. Thus, by applying the first and second epitaxial layers EPL1 and EPL2 of FIG. 7A to the third semiconductor pattern SP3, it may be possible to increase a thickness of the third semiconductor pattern SP3. Meanwhile, for the second inner electrode PO2 at a bottom tier, owing to the second recess region RSP2 of FIG. 7E, a volume of the second inner electrode PO2 may be increased. Accordingly, it may be possible to improve the channel controllability through the second inner electrode PO2.

Referring to FIG. 7F, a third recess region RSP3 may be formed in the first sidewall CSW1 of the first source/drain pattern SD1. The second insulating layer IL2 of the inner spacer IS may fill the third recess region RSP3. The second thickness TK2 of the vertical portion SPO may be increased by the third recess region RSP3.

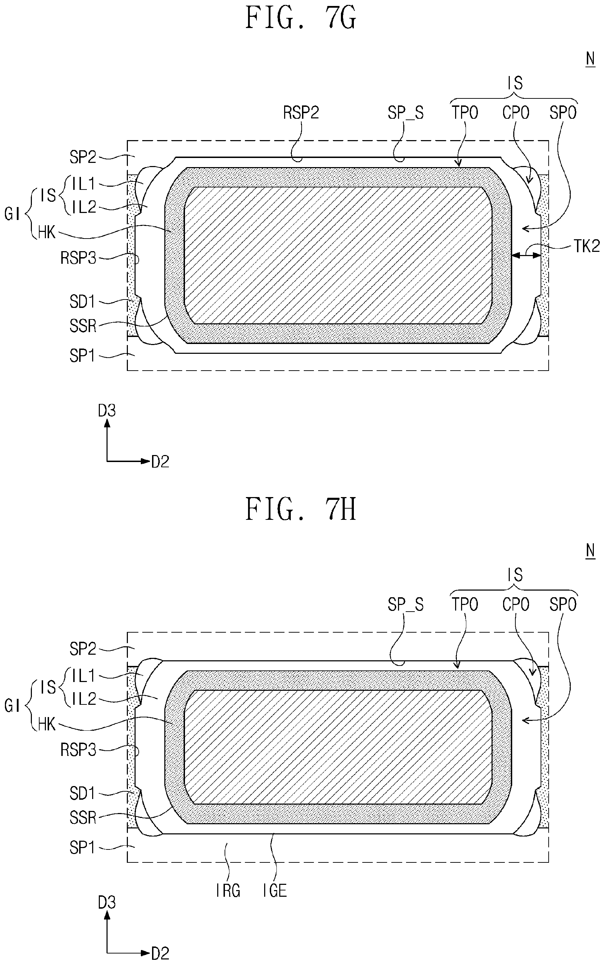

Referring to FIG. 7G, the third recess region RSP3 may be formed in the first sidewall CSW1 of the first source/drain pattern SD1. When compared with the third recess region RSP3 of FIG. 7F, the third recess region RSP3 of FIG. 7G may have a shape extending in the third direction D3.

Referring to FIG. 7H, the third recess region RSP3 may be present on the first sidewall CSW1 of the first source/drain pattern SD1, and the second recess region RSP2 may be absent. For example, the bottom surface SP_S of the second semiconductor pattern SP2 may be lower than the corner portion CPO of the inner spacer IS.

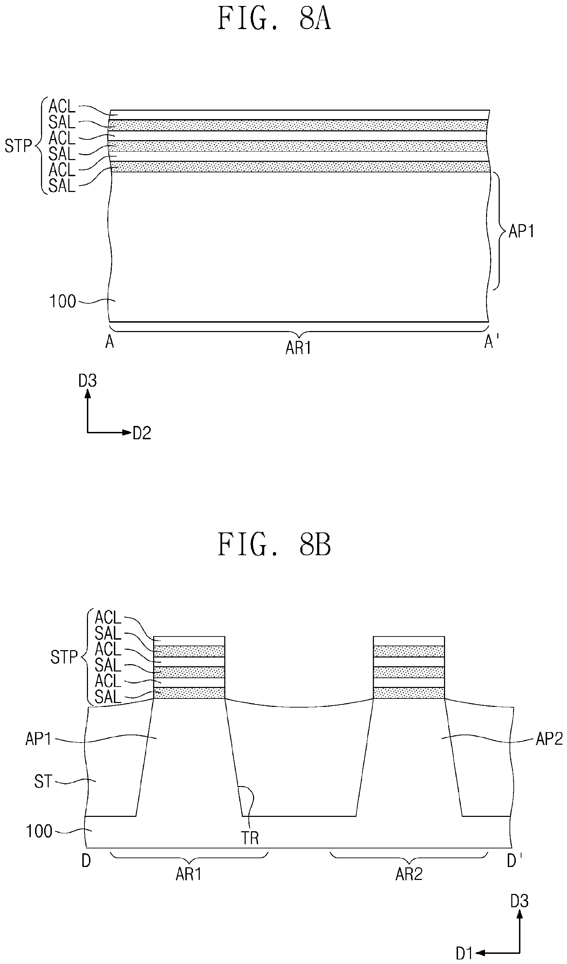

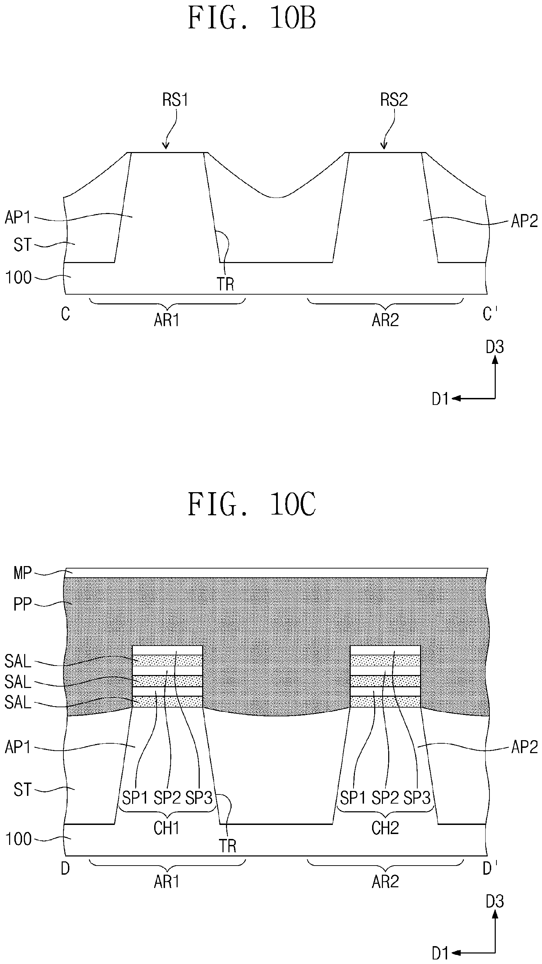

FIGS. 8A to 13C are sectional views illustrating methods of fabricating a semiconductor device, according to some example embodiments of the inventive concepts. In detail, FIGS. 8A, 9A, 10A, 11A, 12A, and 13A are sectional views taken along a line A-A' of FIG. 4. FIGS. 10B, 11B, 12B, and 13B are sectional views taken along a line C-C' of FIG. 4. FIGS. 8B, 9B, 10C, 11C, 12C, and 13C are sectional views taken along a line D-D' of FIG. 4.

Referring to FIGS. 8A and 8B, the substrate 100 including the first and second active regions AR1 and AR2 may be provided. Active layers ACL and sacrificial layers SAL may be alternately stacked on the substrate 100. The active and sacrificial layers ACL and SAL may be formed of or include at least one of silicon (Si), germanium (Ge), or silicon germanium (SiGe), and the active and sacrificial layers ACL and SAL may be formed of different materials from each other.

The sacrificial layer SAL may be formed of or include a material having an etch selectivity with respect to the active layer ACL. For example, the active layers ACL may be formed of or include silicon (Si), and the sacrificial layers SAL may be formed of or include silicon germanium (SiGe). A germanium concentration of each of the sacrificial layers SAL may range from 10 at% to 30 at%.

Mask patterns may be respectively formed on the first and second active regions AR1 and AR2 of the substrate 100. The mask pattern may be a line- or bar-shaped pattern that is extended in the second direction D2.

A patterning process using the mask patterns as an etch mask may be performed to form the trench TR defining the first and second active patterns AP1 and AP2. The first active pattern AP1 may be formed on the first active region AR1. The second active pattern AP2 may be formed on the second active region AR2.

A stacking pattern STP may be formed on each of the first and second active patterns AP1 and AP2. The stacking pattern STP may include the active layers ACL and the sacrificial layers SAL which are alternately stacked. The stacking pattern STP may be formed along with the first and second active patterns AP1 and AP2, during the patterning process.

The device isolation layer ST may be formed to fill the trench TR. In detail, an insulating layer may be formed on the substrate 100 to cover the first and second active patterns AP1 and AP2 and the stacking patterns STP. The device isolation layer ST may be formed by recessing the insulating layer to expose the stacking patterns STP.

The device isolation layer ST may be formed of or include an insulating material (e.g., silicon oxide). The stacking patterns STP may be placed at a level higher than the device isolation layer ST and may be exposed to the outside of the device isolation layer ST. In other words, the stacking patterns STP may protrude vertically above the device isolation layer ST.

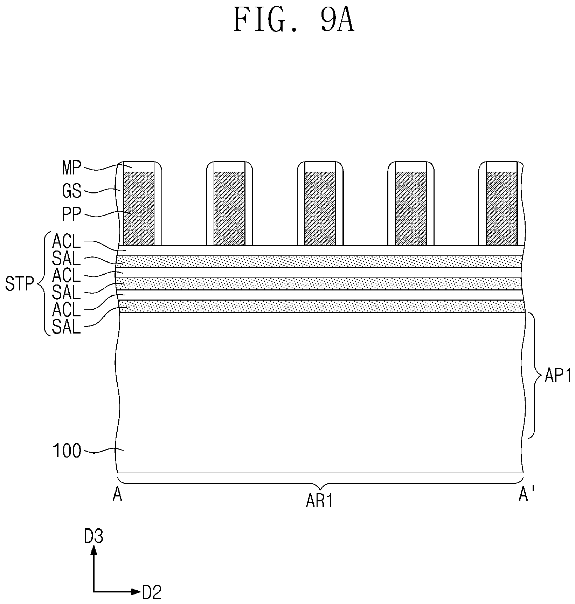

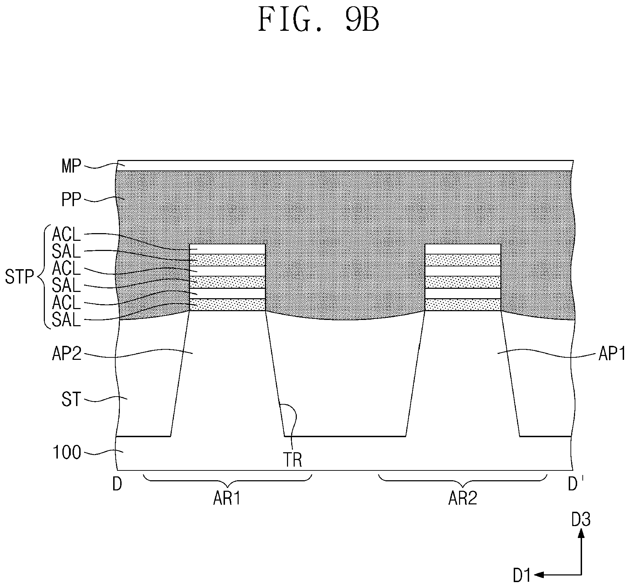

Referring to FIGS. 9A and 9B, sacrificial patterns PP may be formed on the substrate 100 to cross the stacking patterns STP. Each of the sacrificial patterns PP may be a line- or bar-shaped pattern extending in the first direction D1. The sacrificial patterns PP may be arranged at a first pitch in the second direction D2.

In detail, the formation of the sacrificial patterns PP may include forming a sacrificial layer on the substrate 100, forming hard mask patterns MP on the sacrificial layer, and patterning the sacrificial layer using the hard mask patterns MP as an etch mask. The sacrificial layer may be formed of or include polysilicon.

A pair of the gate spacers GS may be formed on opposite side surfaces of each of the sacrificial patterns PP. The formation of the gate spacers GS may include conformally forming a gate spacer layer on the substrate 100 and anisotropically etching the gate spacer layer. In some example embodiments, the gate spacer GS may be a multi-layered structure including at least two layers.

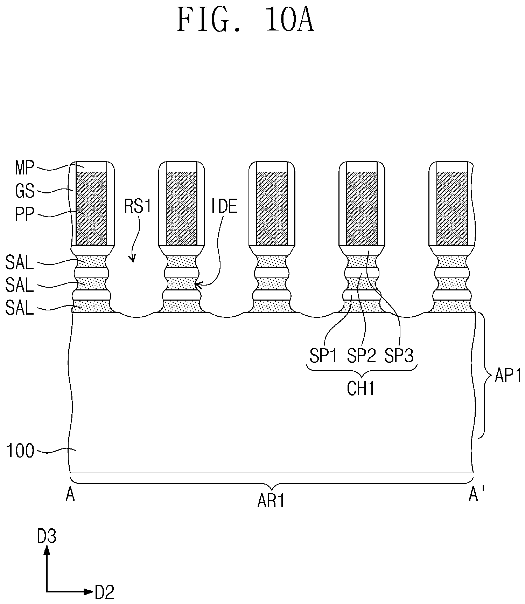

Referring to FIGS. 10A to 10C, the first recesses RS1 may be formed in the stacking pattern STP on the first active pattern AP1. The second recesses RS2 may be formed in the stacking pattern STP on the second active pattern AP2. During the formation of the first and second recesses RS1 and RS2, the device isolation layer ST may also be recessed at both sides of each of the first and second active patterns AP1 and AP2 (e.g., see FIG. 10B).

In detail, the first recesses RS1 may be formed by etching the stacking pattern STP on the first active pattern AP1 using the hard mask patterns MP and the gate spacers GS as an etch mask. The first recess RS1 may be formed between a pair of the sacrificial patterns PP.

In some example embodiments, the formation of the first recess RS1 may include additionally performing a selective etching process on exposed portions of the sacrificial layers SAL. Each of the sacrificial layers SAL may be indented by the selective etching process to form an indent region IDE. Accordingly, the first recess RS1 may be formed to have an inner side surface of a wavy shape. The second recesses RS2 in the stacking pattern STP on the second active pattern AP2 may be formed by the same method as that for the first recesses RS 1.

The first to third semiconductor patterns SP1, SP2, and SP3, which are sequentially stacked between adjacent ones of the first recesses RS1, may be respectively formed from the active layers ACL. The first to third semiconductor patterns SP1, SP2, and SP3 between adjacent ones of the first recesses RS1 may constitute the first channel pattern CH1. The first to third semiconductor patterns SP1, SP2, and SP3 between adjacent ones of the second recesses RS2 may constitute the second channel pattern CH2.

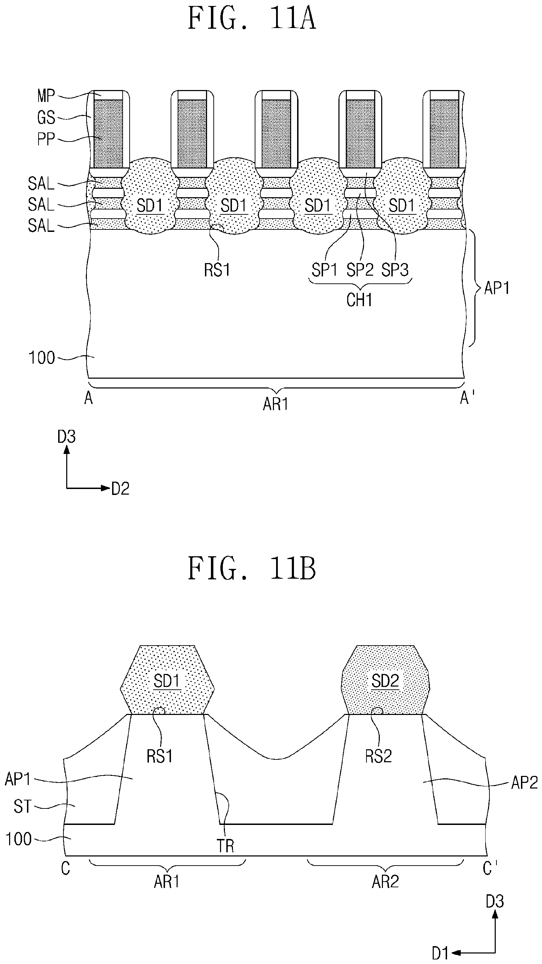

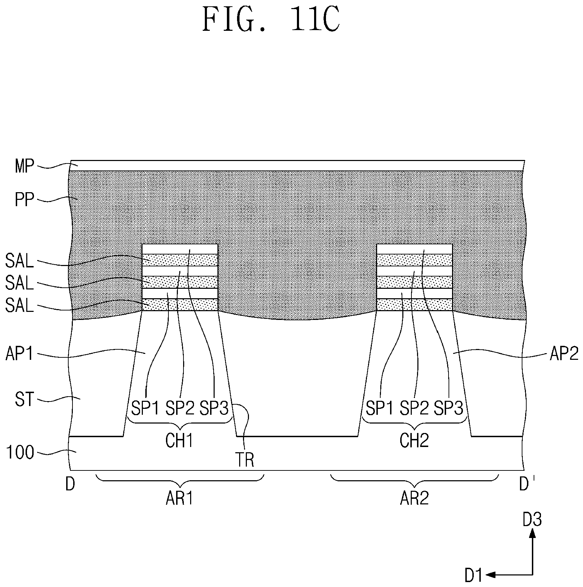

Referring to FIGS. 11A to 11C, the first source/drain patterns SD1 may be formed in the first recesses RS1, respectively. In detail, a SEG process, in which an inner surface of the first recess RS1 is used as a seed layer, may be performed to form an epitaxial layer filling the first recess RS1. The epitaxial layer may be grown using the first to third semiconductor patterns SP1, SP2, and SP3 and the substrate 100, which are exposed by the first recess RS1, as the seed layer. In some example embodiments, the SEG process may include a chemical vapor deposition (CVD) process or a molecular beam epitaxy (MBE) process.

In some example embodiments, the first source/drain pattern SD1 may include the same semiconductor element (e.g., Si) as the substrate 100. During the formation of the first source/drain pattern SD1, the first source/drain pattern SD1 may be doped in-situ with n-type impurities (e.g., phosphorus, arsenic, or antimony). Alternatively, impurities may be injected into the first source/drain pattern SD1, after the formation of the first source/drain pattern SD1.

The second source/drain patterns SD2 may be formed in the second recesses RS2, respectively. In detail, the second source/drain pattern SD2 may be formed by a SEG process using an inner surface of the second recess RS2 as a seed layer.

In some example embodiments, the second source/drain pattern SD2 may be formed of or include a semiconductor material (e.g., SiGe) whose lattice constant is greater than that of a semiconductor material of the substrate 100. During the formation of the second source/drain pattern SD2, the second source/drain pattern SD2 may be doped in-situ with p-type impurities (e.g., boron, gallium, or indium). Alternatively, impurities may be injected into the second source/drain pattern SD2, after the formation of the second source/drain pattern SD2.

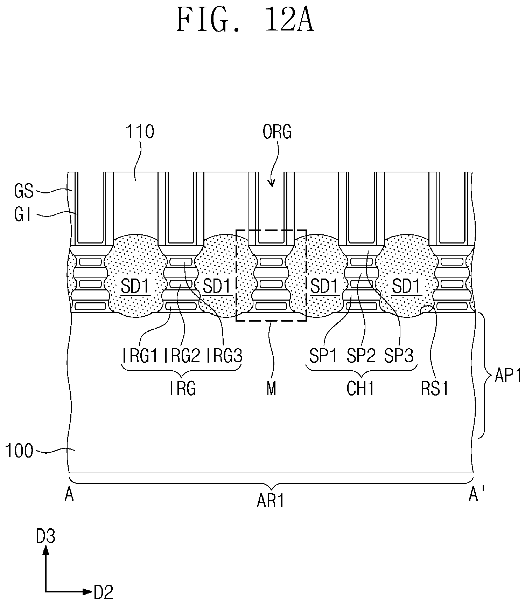

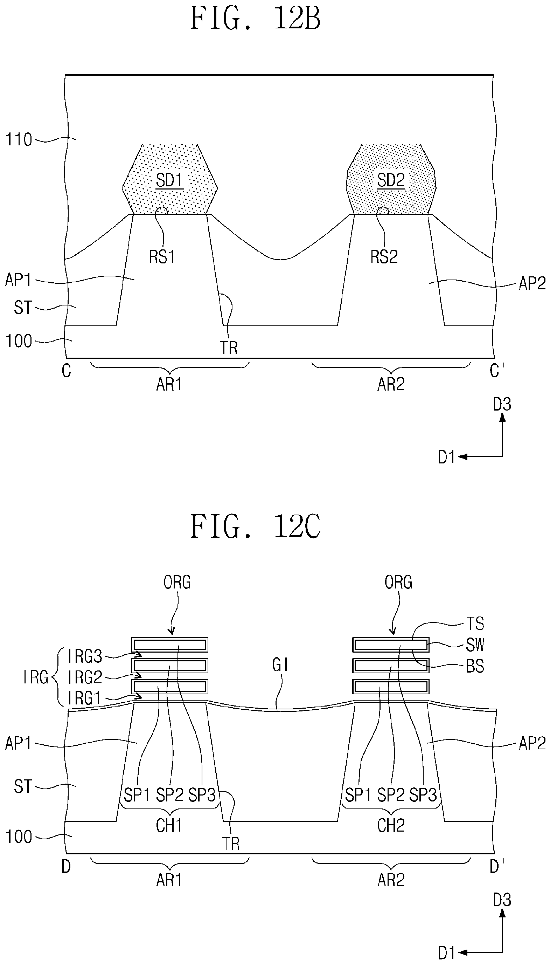

Referring to FIGS. 12A to 12C, the first interlayer insulating layer 110 may be formed to cover the first and second source/drain patterns SD1 and SD2, the hard mask patterns MP, and the gate spacers GS. In some example embodiments, the first interlayered insulating layer 110 may be formed of or include silicon oxide.

The first interlayer insulating layer 110 may be planarized to expose the top surfaces of the sacrificial patterns PP. The planarization of the first interlayer insulating layer 110 may be performed using an etch-back or chemical-mechanical polishing (CMP) process. The hard mask patterns MP may be fully removed during the planarization process. As a result, a top surface of the first interlayer insulating layer 110 may be coplanar with the top surfaces of the sacrificial patterns PP and the top surfaces of the gate spacers GS.

In some example embodiments, the exposed sacrificial patterns PP may be selectively removed. As a result of the removal of the sacrificial patterns PP, an outer region ORG exposing the first and second channel patterns CH1 and CH2 may be formed (e.g., see FIG. 12C). The removal of the sacrificial patterns PP may include a wet etching process which is performed using an etching solution capable of selectively etching polysilicon.

The sacrificial layers SAL exposed through the outer region ORG may be selectively removed to form the inner regions IRG (e.g., see FIG. 12C). In detail, a process of selectively etching the sacrificial layers SAL may be performed to leave the first to third semiconductor patterns SP1, SP2, and SP3 and to remove only the sacrificial layers SAL. The etching process may be chosen to have a high etch rate for a material (e.g., SiGe) having a relatively high germanium concentration. For example, the etching process may be chosen to have a high etch rate for a silicon germanium layer whose germanium concentration is higher than 10 at%.

During the etching process, the sacrificial layers SAL on the first and second active regions AR1 and AR2 may be removed. The etching process may be a wet etching process. An etchant material, which is used in the etching process, may be chosen to quickly remove the sacrificial layer SAL having a relatively high germanium concentration.

Referring back to FIG. 12C, as a result of the selective removal of the sacrificial layers SAL, only the stacked first to third semiconductor patterns SP1, SP2, and SP3 may be left on each of the first and second active patterns AP1 and AP2. Hereinafter, empty regions, which are formed by removing the sacrificial layers SAL, will be referred to as first to third inner regions IRG1, IRG2, and IRG3, respectively. In detail, the first inner region IRG1 may be formed between the active pattern AP1 or AP2 and the first semiconductor pattern SP1, the second inner region IRG2 may be formed between the first semiconductor pattern SP1 and the second semiconductor pattern SP2, and the third inner region IRG3 may be formed between the second semiconductor pattern SP2 and the third semiconductor pattern SP3.

Referring back to FIGS. 12A to 12C, the gate insulating layer GI may be formed on the exposed first to third semiconductor patterns SP1, SP2, and SP3. The gate insulating layer GI may be formed to enclose each of the first to third semiconductor patterns SP1, SP2, and SP3. The gate insulating layer GI may be formed in each of the first to third inner regions IRG1, IRG2, and IRG3. The gate insulating layer GI may be formed in the outer region ORG.

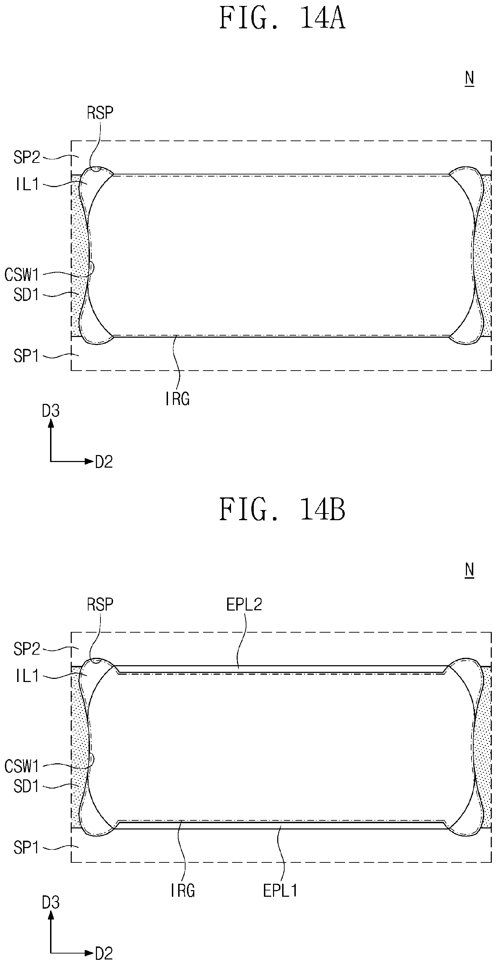

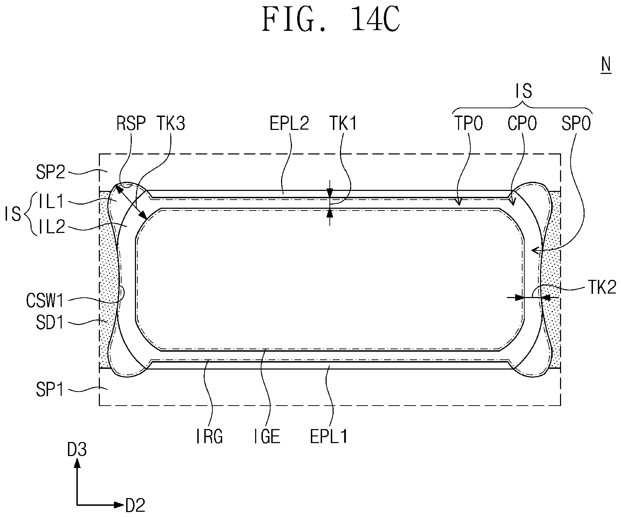

FIGS. 14A, 14B, and 14C are enlarged views illustrating a method of forming the portion N of FIG. 12A, according to some example embodiments of the inventive concepts. Referring to FIG. 14A, the inner region IRG may be formed by selectively removing the sacrificial layer SAL, as described above. The inner region IRG may be located between the pair of the first source/drain patterns SD1.

The inner region IRG may expose the first sidewall CSW1 of the first source/drain pattern SD1. The second inner region IRG2 may expose a top surface of the first semiconductor pattern SP1 and a bottom surface of the second semiconductor pattern SP2. When the inner region IRG is formed by removing the sacrificial layer SAL, an over-etching phenomenon may occur. In this case, the recess region RSP may be formed at a corner of the inner region IRG.

The first insulating layer IL1 may be formed in the inner region IRG. The first insulating layer IL1 may be selectively formed in only the recess region RSP. In detail, a first process may be performed to conformally deposit the first insulating layer IL1 in the inner region IRG. For example, the first insulating layer IL1 may include a silicon oxide layer, a silicon oxynitride layer, or a silicon nitride layer.

A second process may be performed to selectively etch the first insulating layer IL1 in the inner region IRG. The second process may include a wet etching process which is performed using an etching solution capable of selectively etching only the first insulating layer IL1. In some example embodiments, the second process may be performed to expose surfaces of the first and second semiconductor patterns SP1 and SP2.

The first process and the second process may constitute a single cycle process. In some example embodiments, the first insulating layer IL1 may be selectively formed in only the recess region RSP by performing the cycle process at least one time.

A SEG process may be performed on the surfaces of the first and second semiconductor patterns SP1 and SP2 exposed by the first insulating layer IL1. Accordingly, the first epitaxial layer EPL1 may be formed on the first semiconductor pattern SP1, and the second epitaxial layer EPL2 may be formed on the second semiconductor pattern SP2. As a result of the formation of the first epitaxial layer EPL1, a thickness of the first semiconductor pattern SP1 may be increased. The formation of the second epitaxial layer EPL2 may increase the thickness of the second semiconductor pattern SP2.

The second insulating layer IL2 may be formed in the inner region IRG. In an embodiment, the second insulating layer IL2 may include a silicon oxide layer, a silicon oxynitride layer, or a silicon nitride layer. In some example embodiments, the second insulating layer IL2 may be formed of or include the same material (e.g., silicon oxide layer) as the first insulating layer IL1. The first insulating layer IL1 and the second insulating layer IL2 may constitute the inner spacer IS.

The inner spacer IS may include the horizontal portion TPO on the semiconductor pattern SP1-SP3, the vertical portion SPO on the first sidewall CSW1 of the first source/drain pattern SD1, and the corner portion CPO between the horizontal and vertical portions TPO and SPO. The thickness TK2 of the vertical portion SPO may be larger than the thickness TK1 of the horizontal portion TPO. The thickness TK3 of the corner portion CPO may be larger than the thickness TK2 of the vertical portion SPO. The inner spacer IS in the inner region IRG1-IRG3 may define the inner gate space IGE.

The formation of the second insulating layer IL2 may include a cycle process that consists of the first and second processes described above. By performing the cycle process, the thickness TK1 of the horizontal portion TPO of the second insulating layer IL2 may be adjusted to have a value that is larger than the thickness TK2 of the vertical portion SPO.

Next, the high-k dielectric layer HK may be formed in the inner gate space IGE. The inner spacer IS and the high-k dielectric layer HK may constitute the gate insulating layer GI. In some example embodiments, the high-k dielectric layer HK may be formed conformally. For example, in the high-k dielectric layer HK, a thickness in a horizontal direction may be substantially equal to a thickness in a vertical direction.

According to some example embodiments of the inventive concepts, since the thickness TK1 of the horizontal portion TPO of the inner spacer IS is relatively small, an empty space (i.e., the inner gate space IGE), which can be stably filled with the gate electrode GE, may be formed in the inner region IRG. According to some example embodiments of the inventive concepts, the thickness TK3 of the corner portion CPO may have a relatively large value, and this may make it possible to reduce the leakage current of a transistor and the electric characteristics of the transistor.

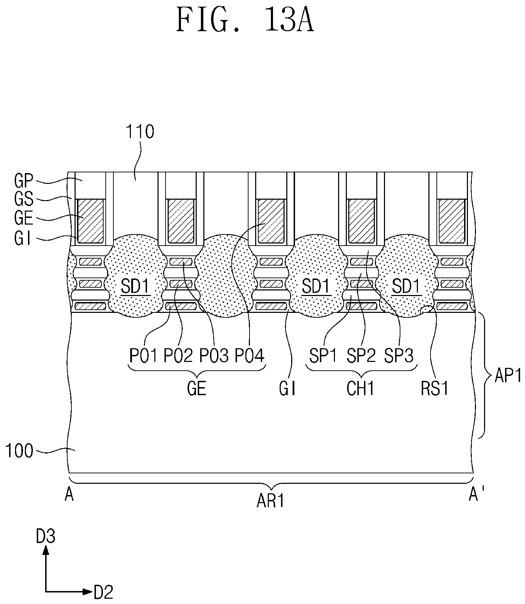

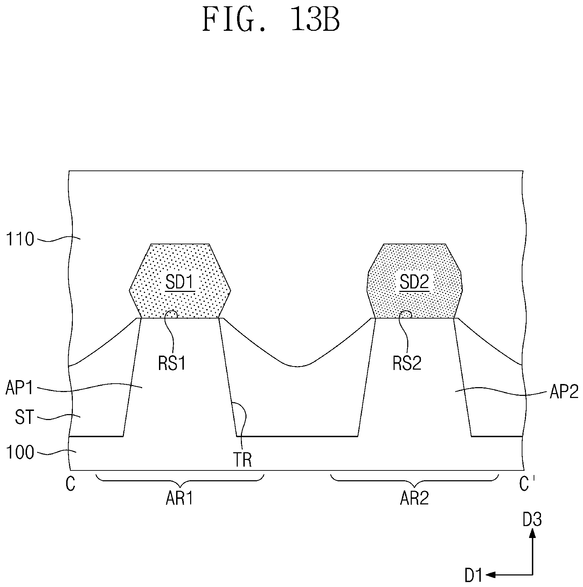

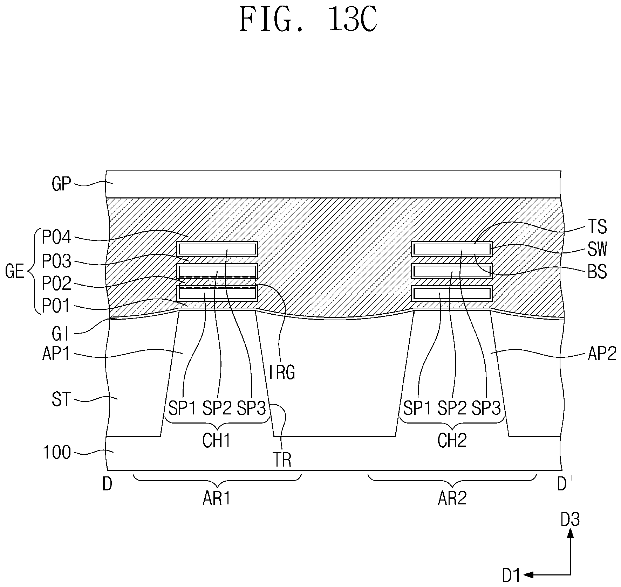

Referring to FIGS. 13A to 13C, the gate electrode GE may be formed on the gate insulating layer GI. The gate electrode GE may include first to third inner electrodes PO1, PO2, and PO3, which are respectively formed in the first to third inner regions IRG1, IRG2, and IRG3, and an outer electrode PO4, which is formed in the outer region ORG. Each of the first to third inner electrodes PO1, PO2, and PO3 may fill the inner gate space IGE of FIG. 14C. The gate electrode GE may be recessed to have a reduced height. The gate capping pattern GP may be formed on the recessed gate electrode GE.

Referring back to FIGS. 5A to 5D, the second interlayer insulating layer 120 may be formed on the first interlayer insulating layer 110. The second interlayer insulating layer 120 may include a silicon oxide layer. The active contacts AC may be formed to penetrate the second and first interlayer insulating layers 120 and 110 and to be electrically connected to the first and second source/drain patterns SD1 and SD2. The gate contact GC may be formed to penetrate the second interlayer insulating layer 120 and the gate capping pattern GP and to be electrically connected to the gate electrode GE.

The formation of each of the active and gate contacts AC and GC may include forming the barrier pattern BM and forming the conductive pattern FM on the barrier pattern BM. The barrier pattern BM may be conformally formed and may include a metal layer and/or a metal nitride layer. The conductive pattern FM may be formed of or include a low resistance metal.

The division structures DB may be respectively formed in the first and second borders BD1 and BD2 of the single height cell SHC. The division structure DB may penetrate the gate capping pattern GP and the gate electrode GE and may be extended into the active pattern AP1 or AP2. The division structure DB may be formed of or include an insulating material (e.g., silicon oxide or silicon nitride).

The third interlayer insulating layer 130 may be formed on the active contacts AC and the gate contacts GC. The first metal layer M1 may be formed in the third interlayer insulating layer 130. The fourth interlayer insulating layer 140 may be formed on the third interlayer insulating layer 130. The second metal layer M2 may be formed in the fourth interlayer insulating layer 140.

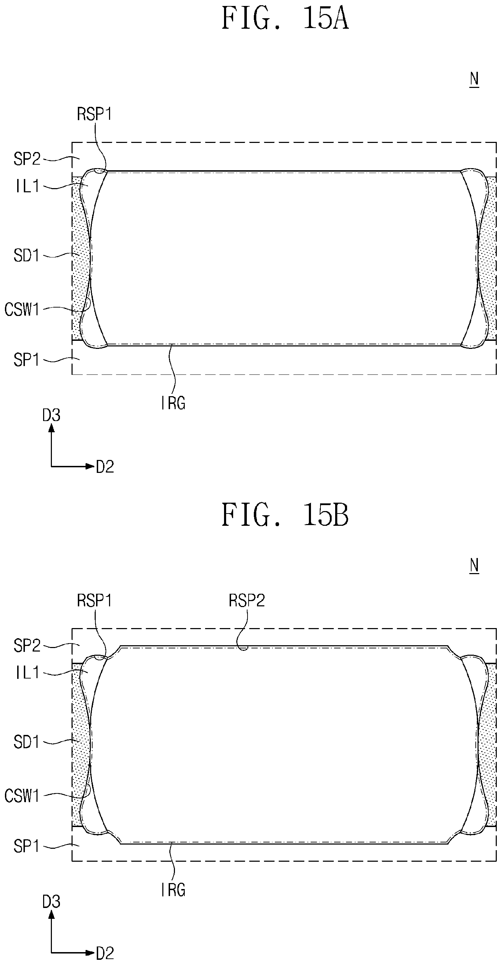

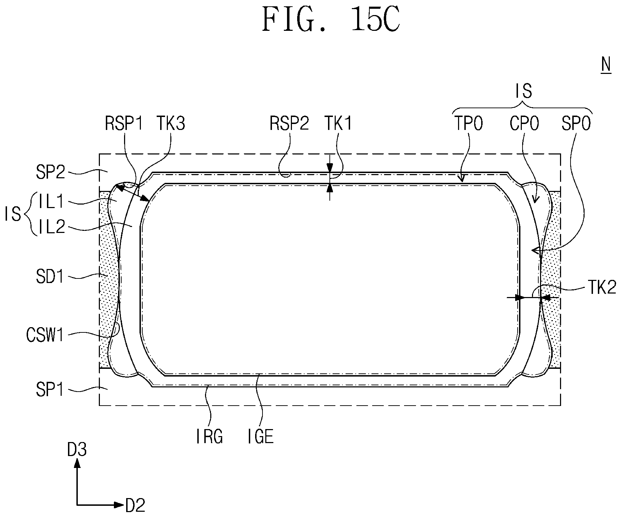

FIGS. 15A, 15B, and 15C are enlarged views illustrating methods of forming the portion N of FIG. 12A, according to some example embodiments of the inventive concepts. Referring to FIG. 15A, the inner region IRG may be formed by selectively removing the sacrificial layer SAL, as described above. When the inner region IRG is formed by removing the sacrificial layer SAL, an over-etching phenomenon may occur. In this case, the first recess region RSP1 may be formed at a corner of the inner region IRG.

The first insulating layer IL1 may be formed in the inner region IRG. The first insulating layer IL1 may be selectively formed in only the first recess region RSP1. The first insulating layer IL1 may be formed using a method that is substantially the same as the one previously described for the first insulating layer IL1 previously described with reference to FIG. 14A.

Referring to FIG. 15B, a trimming process may be performed on surfaces of the first and second semiconductor patterns SP1 and SP2 that are exposed by the first insulating layer IL1. The trimming process may include a process of selectively etching only the exposed surfaces of the first and second semiconductor patterns SP1 and SP2. As a result of the trimming process, the second recess region RSP2 may be formed on the exposed surfaces of the first and second semiconductor patterns SP1 and SP2. As a result of the formation of the second recess region RSP2, the volume of the inner region IRG may be further increased.

Referring to FIG. 15C, the second insulating layer IL2 may be formed in the inner region IRG. The first and second insulating layers IL1 and IL2 may constitute the inner spacer IS. The second insulating layer IL2 may be formed using a method that is substantially the same as the one previously described with reference to FIG. 14C.

The inner spacer IS may include the horizontal portion TPO on the semiconductor pattern SP1-SP3, the vertical portion SPO on the first sidewall CSW1 of the first source/drain pattern SD1, and the corner portion CPO between the horizontal and vertical portions TPO and SPO. The thickness TK2 of the vertical portion SPO may be larger than the thickness TK1 of the horizontal portion TPO. The thickness TK3 of the corner portion CPO may be larger than the thickness TK2 of the vertical portion SPO. The inner spacer IS in the inner region IRG1-IRG3 may define the inner gate space IGE.

Next, the high-k dielectric layer HK may be formed in the inner gate space IGE. The inner spacer IS and the high-k dielectric layer HK may constitute the gate insulating layer GI. In some example embodiments, the high-k dielectric layer HK may be formed conformally. For example, a thickness of the high-k dielectric layer HK in a horizontal direction may be substantially equal to a thickness in a vertical direction.

In a three-dimensional field effect transistor according to some example embodiments of the inventive concepts, a gate insulating layer may include an inner spacer that is configured to prevent or reduce in likelihood a leakage current of a gate. The inner spacer may be used to selectively increase a thickness of a corner portion, and this may make it possible to reduce the leakage current and provide an inner gate space of a sufficiently large volume. Thus, the inner gate space may be stably filled with a gate electrode. As a result, it may be possible to improve the electrical and reliability characteristics of the semiconductor device.

While some example embodiments of the inventive concepts have been particularly shown and described, it will be understood by one of ordinary skill in the art that variations in form and detail may be made therein without departing from the spirit and scope of the attached claims.

## Claims

1. A semiconductor device, comprising:
a substrate including an active pattern;
a channel pattern on the active pattern, the channel pattern including a first semiconductor pattern and a second semiconductor pattern, which are stacked to be spaced apart from each other;
a source/drain pattern connected to the first and second semiconductor patterns;
a gate electrode on the channel pattern, the gate electrode including an inner electrode interposed between the first and second semiconductor patterns; and
a gate insulating layer between the first and second semiconductor patterns and the inner electrode,
wherein the gate insulating layer includes a high-k dielectric layer enclosing the inner electrode and an inner spacer on the high-k dielectric layer,
the inner spacer includes,
a horizontal portion between the high-k dielectric layer and the second semiconductor pattern,
a vertical portion between the high-k dielectric layer and the source/drain pattern, and
a corner portion connecting the horizontal portion to the vertical portion,
a first thickness of the horizontal portion is smaller than a second thickness of the vertical portion, and
the second thickness is smaller than a third thickness of the corner portion.

2. The semiconductor device of claim 1, wherein an inner region is defined between the first and second semiconductor patterns and the source/drain pattern,
the inner electrode and the gate insulating layer are provided in the inner region,
the inner region includes a first recess region in a corner thereof,
the first recess region is recessed in a direction away from the inner electrode, and
the corner portion is provided in the first recess region.

3. The semiconductor device of claim 2, wherein the inner spacer includes a first insulating layer, which is selectively provided in the first recess region, and a second insulating layer enclosing the high-k dielectric layer.

4. The semiconductor device of claim 3, wherein a thickness of the second insulating layer in the horizontal portion is smaller than a thickness of the second insulating layer in the vertical portion.

5. The semiconductor device of claim 3, wherein
each of the horizontal and vertical portions include the second insulating layer, and the corner portion includes the first insulating layer and the second insulating layer.

6. The semiconductor device of claim 1, further comprising:
a first epitaxial layer interposed between the second semiconductor pattern and the horizontal portion.

7. The semiconductor device of claim 6, further comprising:
a second epitaxial layer interposed between the source/drain pattern and the vertical portion.

8. The semiconductor device of claim 2, wherein the inner region further comprises:
a second recess region that is recessed toward the second semiconductor pattern, and
the horizontal portion is provided in the second recess region.

9. The semiconductor device of claim 8, wherein
the second semiconductor pattern includes a bottom surface defined by the second recess region, and
the bottom surface is higher than the corner portion.

10. The semiconductor device of claim 1, wherein
the source/drain pattern includes a protruding portion that protrudes toward the inner electrode,
a sidewall of the protruding portion has a convex profile toward the inner electrode, the inner spacer defines an inner gate space therein,
the high-k dielectric layer and the inner electrode are provided in the inner gate space, and
a side of the inner gate space, which is adjacent to the sidewall of the protruding portion, has a flat profile that is parallel to a vertical direction.
